Europäisches Patentamt

European Patent Office

Office européen des brevets

(19)

(11) EP 0 936 683 A1

(12) EUROPEAN PATENT APPLICATION
published in accordance with Art. 158(3) EPC

(43) Date of publication:
18.08.1999 Bulletin 1999/33

(51) Int. Cl.⁶: H01L 33/00

(21) Application number: 98905698.1

(86) International application number:
PCT/JP98/00826

(22) Date of filing: 27.02.1998

(87) International publication number:
WO 99/00852 (07.01.1999 Gazette 1999/01)

(84) Designated Contracting States:
DE FR GB

(30) Priority: 27.06.1997 JP 17169197
12.09.1997 JP 24919797
05.12.1997 JP 33569797

(71) Applicant:
IWASAKI ELECTRIC CO., LTD.
Tokyo 105 (JP)

(72) Inventors:
• SUEHIRO, Yoshinobu
  Iwasaki Electric Co., Ltd.
  Gyoda-shi Saitama 361-0021 (JP)
• SATO, Takashi
  Iwasaki Electric Co., Ltd.
  Gyoda-shi Saitama 361-0021 (JP)
• HATANAKA, Mitsuyuki
  Iwasaki Info. Systems Co., Ltd
  Kitasaitamagun Saitama 365-0007 (JP)
• UCHIDA, Koji
  Iwasaki Electric Co., Ltd.
  Gyoda-shi Saitama 361-0021 (JP)

(74) Representative: Kador & Partner
Corneliusstrasse 15
80469 München (DE)

(54) REFLECTION TYPE LIGHT EMITTING DIODE

(57) A concave reflection surface (18) is provided on a light-emitting surface side of light-emitting element (11) and shaped as approximately paraboloid of revolution. A center of the light-emitting surface of the light-emitting element (11) is locate at the focal point of the concave reflection surface (18). A radiation surface (19) is provided on the rear side of the light-emitting element (11). The radiation surface (19) has formed on its circumference a protruded portion (21) protruded from the radiation surface (19). Such light-emitting diode is produced by transfer molding in which the concave reflection surface (18) is molded by a lower molding die and the radiation surface (19) is molded by an upper molding die. At that time, since an air remaining on the upper surface of the upper molding die is gathered in the upper molding die at its portion opposing the protruded portion (21), the air layer can be prevented from being left in the upper molding die at its portion opposing the radiation surface (19).

FIG. 1

## Description

Technical Field:

The present invention relates to a reflection type light-emitting diode including a concave reflection surface to reflect light emitted from a light-emitting element so that reflected light may be radiated to the outside.

Background Art:

Heretofore, there have been devised light-emitting diodes having a variety of structures. Of such various light-emitting diodes,typical light-emitting diodes are a lens type light-emitting diode and a reflection type light-emitting diode, for example. While the lens type light-emitting diode includes an optical surface to directly radiate light emitted from a light-emitting element to the outside, the reflection type light-emitting diode includes a concave reflection surface to reflect light emitted from a light-emitting element so that reflected light may be radiated to the outside.

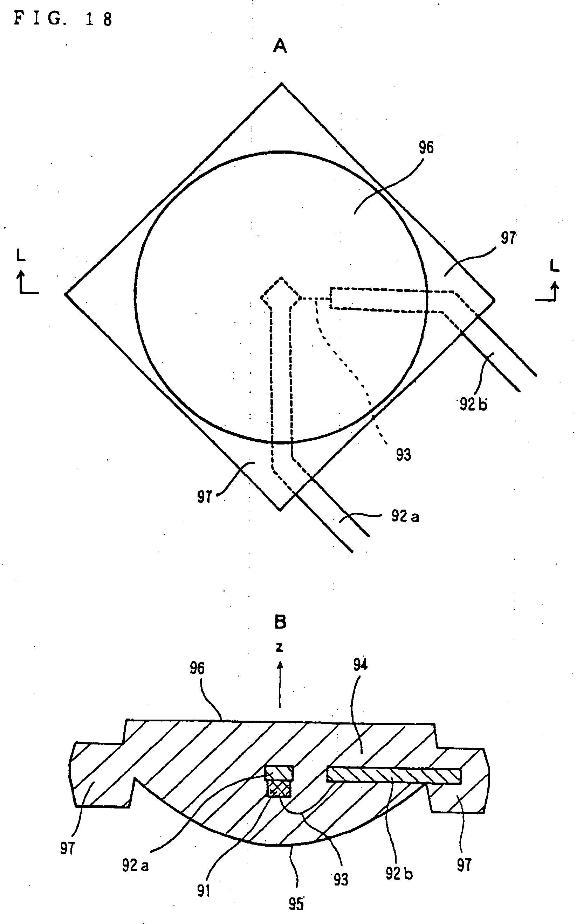

FIG. 18A is a schematic front view illustrating a reflection type light-emitting diode according to the related art. Fig. 18B is a schematic cross-sectional view of the reflection type light-emitting diode taken along the line L - L in FIG. 18A. In FIG. 18B, the z-axis represents the center axis of the concave reflection surface.

As shown in FIGS. 18A and 18B, the reflection type light-emitting diode comprises a light-emitting element 91, lead assemblies 92a, 92b, a bonding wire 93, a light-transmissible material 94, a concave reflection surface 95, a radiation surface 96 and a lead deriving portion 97.

The light-emitting element 91 is mounted on one end of the lead assembly 92a, and the light-emitting element 91 and the lead assembly 92b are electrically interconnected by the bonding wire 93. The light-emitting element 91 and the tip end portions of the lead assemblies 92a, 92b and the bonding wire 93 are integrally sealed by the light-transmissible material 94. The concave reflection surface 95 is produced by mirror-grinding one surface of the light-transmissible material 94 according to a suitable method such as plating or metal vapor deposition, and is formed on the side opposing the light-emitting surface of the light-emitting element 91. A planar radiation surface 96 is formed on the light-transmissible material 94 at its surface opposite to the concave reflection surface 95. The lead deriving portion 97 is adapted to lead the lead assemblies 92a, 92b to the outside, and is formed around the outside of the concave reflection surface 95. The lead assemblies 92a and 92b are led out from the side surface off the lead deriving portion 97 in the same direction.

The radiation surface 96 is protruded from the lead deriving portion 97, whereby the reflection type light-emitting diode may be attached to a jig or the like with ease. Thus, the reflection type light-emitting diode may be mounted with a sufficiently high accuracy.

As a method of manufacturing the reflection type light-emitting diode, there is used transfer molding method in which the lead frame is held by upper and lower molding dies and thermosetting resin is injected between the molding dies and hardened. The reason that the transfer molding is used is that the reflection type light-emitting diode needs the reflection surface and the radiation surface formed on both sides of the lead frame unlike the lens type light-emitting diode in which a lens is formed on only one side. the lens type light-emitting diode but also the reflection surface and the radiation surface formed on both sides of the lead frame. Then, the molded product is ejected from the molding die and unnecessary portions of the lead frame are removed by cutting thereby resulting in the reflection type light-emitting diode shown in FIGS. 18A, 18B being completed.

When the light-emitting element 91 is energized, the light-emitting element 91 is excited to produce light. The light produced from the light-emitting element 91 is reflected by the concave reflection surface 95, and radiated from the radiation surface 96 to the outside. Therefore, light emitted from the light-emitting element 91 can be effectively radiated to the front. In particular, since not only light radiated from the light-emitting element 91 to the center axis direction (z-axis direction) but also light radiated from the light-emitting element 91 in the direction nearly perpendicular to the z-axis direction can be controlled by the concave reflection surface 95, the reflection type light-emitting diode has a characteristic that its external radiation efficiency is high. From this standpoint, the reflection type light-emitting diode differs from the lens type light-emitting diode which is unable to effectively radiate light, emitted from the light-emitting element in the direction substantially perpendicular to its center axis direction, to the outside.

The first problem that the related-art reflection type light-emitting diode encounters will be described below. That is, when the light-emitting diode is manufactured, an air left on the upper surface of the upper molding die produces layers to make it impossible to accurately form the reflection surface or the radiation surface which is identical to the shape of the upper molding die. Specifically, when the concave reflection surface is molded by the lower molding die and the radiation surface is molded by the upper molding die, even though the upper molding die is designed so as to form the flat radiation surface, a concavity such as a sink mark produced when a thermosetting resin is hardened is produced on a part or whole of the radiation surface by the layer produced by the remaining air. When the radiation surface is deformed as described above, such deformed radiation surface not only causes a problem from a product

EP 0 936 683 A1

appearance standpoint but also causes light to be refracted on the radiation surface, thereby exerting a bad influence upon the radiation characteristic of the reflection type light-emitting diode. Conversely, when the radiation surface is molded by the lower molding die and the concave reflection surface is molded by the upper molding die, a concavity such as a sink mark produced when a thermosetting resin is hardened is produced on a part or whole of the concave reflection surface by the layer produced by the remaining air. When the concave reflection surface is deformed as described above, the concave reflection surface is unable to control light emitted from the light-emitting element accurately, thereby resulting in the light radiation characteristic of the reflection type light-emitting diode being degraded. Such problems as described above become remarkable in the use in which a ray of light is controlled, i.e. rays of light radiated in the respective directions should be optically controlled with a high accuracy , such as when light is radiated in the distant place by parallel rays or when light is condensed at one point in order to obtain a high light radiation density.

Also, the reflection type light-emitting diode according to the related art encounters with the second problem which follows. As a method of producing lead frames, there are generally available etching work or press punching work. In the etching work, its printing plate is produced inexpensively and can be made with ease. On the contrary, in the press punching work, although its punching die is produced expensively and cannot be produced with ease, the press punching work is superior to the etching work from a standpoint of mass-productivity. For this reason, most of the light-emitting diodes including the lens type light-emitting diode uses lead frames produced by press punching work. However, when lead frames are produced by press punching work, a phenomenon in which the portion corresponding to the end of the lead assembly is displaced in the direction perpendicular to the surface of the lead frame as the width of the lead assembly is reduced. i.e, so-called lead warping phenomenon becomes remarkable.

In the reflection type Light-emitting diode, since the light-emitting element 91 is disposed at the center position when the concave reflection surface 95 is seen from the front, one end of the lead assembly 92a is located at the center position of the concave reflection surface 95. On the other hand, since the portions in which the lead assemblies 92a, 92b overlap with the radiation surface 96 when the concave reflection surface 95 is seen from the front shield light reflected on the concave reflection surface 95, the widths of the lead assemblies 92a, 92b should be reduced as much as possible. Therefore, when the reflection type light-emitting diode is manufactured by using the lead frame produced by press punching work, due to the lead warping phenomenon, the portion in which the light-emitting element 91 is mounted on the lead assembly 92a is displaced in the z-axis direction. There is then the problem that alignment accuracy of the light-emitting element 91 relative to the concave reflection surface 95 is degraded. As a result, the concave reflection surface 95 is unable to accurately control light emitted from the light-emitting element in the directions other than the z-axis direction. Hence, the optical radiation characteristics are fluctuated, and so it becomes impossible to obtain the characteristics as they wanted to have in the design Here, the amount of displacement in the z-axis direction of the portion in which the light-emitting element 91 is mounted on the lead assembly 92a due to the lead warping phenomenon becomes remarkable as the diameter of the concave reflection surface 95 increases.

Unlike the reflections type light-emitting diode, the lens type light-emitting diode has no such limitations that the width of the lead assembly should be reduced. The reason for this is that the lens type light-emitting diode includes the optical surface to directly radiate light, emitted from the light-emitting element, to the outside, so that the lead assembly is prevented from shielding light. Moreover, since the lens type light-emitting element cannot sufficiently control light radiated from the light-emitting element in the direction nearly perpendicular to its center axis direction, the positional displacement of the light-emitting element in the center axis direction of the light-emitting element hardly affects the light radiation characteristics. Therefore, it is sufficient that the lens-type light-emitting diode may be manufactured by using the lead frame made by press punching work.

Further, in the reflection type light-emitting diode, since the light-emitting element 91 is mounted on one end of the lead assembly 92a, heat generated from the light-emitting element 91 is conducted to the other end of the lead assembly 92a. As a consequence, since heat generated from the light-emitting element 91 is radiated to the outside only from the side of the other end of the lead assembly 92a, there is the problem that the reflection type light-emitting diode has poor heat-radiation property. In particular, the problem of such heat-radiation property becomes remarkably serious in a light-emitting diode arrangement comprising the array of a plurality of reflection type light-emitting diodes.

In view of the aforesaid aspects, it is an object of the present invention, to provide a reflection type light-emitting diode in which a molding accuracy of optical surfaces, that is, a concave reflection surface and a radiation surface can be improved.

It is another object of the present invention to provide a reflection type, light-emitting diode in which a positional accuracy of a light-emitting element relative to a concave reflection surface can be held with a stability and a heat-radiation property can be improved.

It is still another object of the present invention to obtain a reflection type light-emitting diode in which a molding accuracy of the optical surfaces are can be improved and the positional accuracy of the light-emitting element relative to the concave reflection surface can be held with an excellent stability, so that the reflection type light-emitting diode may optically control rays of light with a high accuracy.

Disclosure of Invention:

In order to attain the aforementioned objects, according to the present invention, there is provided a reflection type light-emitting diode which is comprised of a light-emitting element, a lead assembly for supplying electric power to the light-emitting element, a light-transmissible material for sealing the light-emitting element and the lead assembly, a concave reflection surface provided in an opposing relation to the light-emitting surface of the light-emitting element and a radiation surface for radiating light reflected on the concave reflection surface to the outside, wherein said radiation surface has around its circumference formed a protruded portion protruded from said radiation surface, and said reflection type light-emitting diode is made by a molding method in which said concave reflection surface is molded by a lower molding die and said radiation surface is molded by an upper molding die.

Also, in order to attain the aforementioned objects, according to the present invention, there is provided a reflection type light-emitting diode which is comprised of a plurality of light-emitting elements arrayed rectilinearly, a lead assembly for supplying electric power to the plurality of light-emitting elements, a light-transmissible material for sealing the plurality of light-emitting elements and the lead assembly, a concave cylinder reflection surface provided in an opposing relation to the light-emitting surfaces of the plurality of light-emitting elements and a radiation surface for radiating light reflected on the concave cylinder reflection surface to the outside, wherein the radiation surface has around its circumference formed a protruded portion protruded from the radiation surface and said reflecting type light-emitting diode is made by a molding method in which said concave cylinder reflection surface is molded by a lower molding die and said radiation surface is molded by an upper molding die.

According to the present invention, the reflection type light-emitting diode is produced by molding in which the radiation surface has around its circumference formed a protruded portion protruded from the radiation surface and the concave reflection surface or the concave cylinder reflection surface is molded by a lower molding die and the radiation surface is molded by an upper molding die. Thus, when the reflection type light-emitting diode is produced by such molding, since an air remaining on the upper surface of the upper molding die is gathered in the upper molding die at its portion opposing the protruded portion, the air layer can be prevented from being left in the upper molding die at its portion opposing the radiation surface. Therefore, the radiation surface can be accurately produced with exactly the same shape as that of the upper molding die, thereby making it possible to improve an accuracy with which the radiation surface is molded. With respect to the concave reflection surface or the concave cylinder reflection surface, the problem of the remaining air layer does not arise, and hence the concave reflection surface or the concave cylinder reflection surface can be accurately produced with exactly the same shape as that of the lower molding die.

Although the molding die of the planar optical surface may be produced with ease, the problem of the remaining air layer is remarkable as compared with the case in which the upper molding die molds the flat surface. Therefore, the present invention may effectively be applied to the reflection type light-emitting diode in which the radiation surface is planar. In the reflection type light-emitting diode according to the related art, when a distance between the surface of the lead assembly opposing the radiation surface and the radiation surface increases in excess of about 1.0 mm, a sink mark produced when the resin is hardened is enlarged, which causes not only the problem of controlling rays of light to become serious but also the problem of the appearance to become remarkable. Accordingly, the present invention can be effectively applied to such case. Moreover, since the amount of air left on the upper surface of the upper molding die decreases as such distance decreases, even when the air layer remains on the upper molding die at its portion opposing the radiation surface, the influence exerted upon the accuracy with which the radiation surface is molded can be decreased. However, due to the reason of the manufacturing standpoint which will be described later on, the distance between the surface of the lead assembly opposing the radiation surface side and the radiation surface should preferably be selected to be greater than 0.3 mm.

In order to attain the above-mentioned objects, according to the present invention, there is provided a reflection type light-emitting diode which is comprised of a light-emitting element, a first lead assembly having a mount for mounting the light-emitting element, a second lead assembly interconnected to the light-emitting element by a wire, a concave reflection surface provided in an opposing relation to the light-emitting surface of the light-emitting element, a radiation surface for radiating light reflected on the concave reflection surface to the outside and a light-transmissible material for sealing the light-emitting element and a part of the first lead assembly and the second lead assembly and filling a spade between the concave reflection surface and the radiation surface, wherein said first lead assembly is shaped so as to cross said concave reflection surface substantially rectilinearly when said concave reflection surface is seen from the front and both end portions of said first lead assembly are led out to the outside from the side surface of said light-transmissible material.

Since the first lead assembly is shaped so as to cross the concave reflection surface approximately rectilinearly when the concave reflection surface is seen from the front, the light-emitting element is mounted at approximately a center portion of the first lead assembly. Thus, even when the lead frame having the above-mentioned first lead assembly is produced by press punching work, the mount of the first lead assembly is deformed extremely slightly by such press punching work. Therefore, the reflection type light-emitting diode is produced by using such lead frame, whereby the positional accuracy of the light-emitting element relative to the concave reflection surface can be held with a high stability. Thus, not only light radiated from the light-emitting element to the direction of its center axis but also light radiated in the direction substantially perpendicular to the center axis direction can be controlled by the concave reflection surface satisfactorily and can be therefore radiated to the outside.

Also, since the respective ends of the first lead assembly are led out to the outside from the side surface of the light-transmissible material, heat generated from the light-emitting element can be conducted to the respective ends of the first lead assembly in the two directions. Thus, heat conducted from the light-emitting element to the first lead assembly can be radiated to the outside from the respective ends of the first lead assembly, and of heat conducted from the light-emitting element to the first lead assembly, an amount of heat radiated to the outside through the radiation surface can be increased. Therefore, the reflection type light-emitting diode according to the present invention can improve a heat radiation property.

Brief Description of Drawings:

FIG. 1A is a schematic front view illustrating a reflection type light-emitting diode according to a first embodiment of the present invention;

FIG. 1B is a schematic cross-sectional view of the reflection type light-emitting diode taken along the line A - A in FIG. 1A;

FIG. 2 is a diagram used to explain the manner in which a shape of a concave reflection surface in the reflection type light-emitting diode according to the first embodiment is designed;

FIG. 3 is a diagram used to explain another manner in which the shape of the concave reflection surface in the reflection type light-emitting diode according to the first embodiment is designed;

FIG. 4 is a schematic cross-sectional view illustrating a reflection type light-emitting diode of a condenser-type formed by a combination of the reflection type light-emitting diode according to the first embodiment and a condenser lens;

FIG. 5 is a schematic cross-sectional view illustrating a reflection type light-emitting diode of a condenser-type which is a modified example of the reflection type light-emitting diode according to the first embodiment;

FIG. 6A is a schematic front view of a reflection type light-emitting diode according to a second embodiment of the present invention;

FIG. 6B is a schematic cross-sectional view of the reflection type light-emitting diode taken along the line B - B in FIG. 6A;

FIG. 7A is a schematic front view illustrating a reflection type light-emitting diode according t a third embodiment of the present invention;

FIG. 7B is a schematic cross-sectional view of the reflection type light-emitting diode taken along the line C - C in FIG. 7A;

FIG. 7C is a schematic cross-sectional view of the reflection type light-emitting diode taken along the line D - D in FIG. 7A;

FIG. 8A is a diagram showing an optical path of light on the y - z plane in which light emitted from a light-emitting element of the reflection type light-emitting diode according to the third embodiment becomes incident on a first concave columnar plane-like reflection surface;

FIG. 8B is a diagram showing an optical path of light on the plane including the x-axis of light which is introduced into the first concave columnar plane-like reflection surface from a light-emitting element of the reflection type light-emitting diode;

FIG. 9A is a diagram showing an optical path of light on the y - z plane in which light emitted from a light-emitting element of the reflection type light-emitting diode according to the third embodiment becomes incident on a second concave columnar plane-like reflection surface;

FIG. 9B is a diagram showing an optical path of light on the plane including the x-axis of light which is introduced into the second concave columnar plane-like reflection surface from a light-emitting element of the reflection type light-emitting diode;

FIG. 10A is a schematic front view illustrating a reflection type light-emitting diode according to a fourth embodiment of the present invention;

FIG. 10B is a schematic side view illustrating the reflection type light-emitting diode from the E - E direction of FIG. 10A;

FIG. 10C is a schematic side view illustrating the reflection type light-emitting diode from the F - F direction of FIG. 10A;

FIG. 11 is a schematic front view illustrating a light-emitting diode arrangement comprising the reflection type light-emitting diodes according to the fourth embodiment;

FIG. 12 is a fragmentary cross-sectional view illustrating the light-emitting diode arrangement taken along the line G - G in FIG. 11;

FIGS. 13A and 13B are diagrams showing measured results obtained when the illuminance distribution was simulated;

FIG. 14 is a diagram used to explain a modified example of the reflection type light-emitting diode according to the fourth embodiment;

FIG. 15A is a schematic front view illustrating a reflection type light-emitting diode according to a fifth embodiment of the present invention;

FIG. 15B is a schematic cross-sectional view illustrating the reflection type light-emitting diode from the H - H direction in FIG. 15A;

FIG. 15C is a schematic cross-sectional view illustrating the reflection type light-emitting diode from the I - I direction in FIG. 15A;

FIG. 16A is a schematic front view illustrating a mount of a first lead assembly in the reflection type light-emitting diode according to the fifth embodiment;

FIG. 16B is a schematic side view illustrating the mount of the first lead assembly from the J - J direction in FIG. 16A;

FIG. 17A is a schematic front view illustrating the mount obtained after the center of the mount was treated by punching work in the fifth embodiment;

FIG. 17B is a schematic side view illustrating the mount from the K - K direction in FIG. 17A;

FIG. 18A is a schematic front view illustrating a reflection type light-emitting diode according to the related art; and

FIG. 18B is a schematic cross-sectional view of the light-emitting diode taken along the line L - L in FIG. 18A.

Best Mode for Carrying Out the Invention:

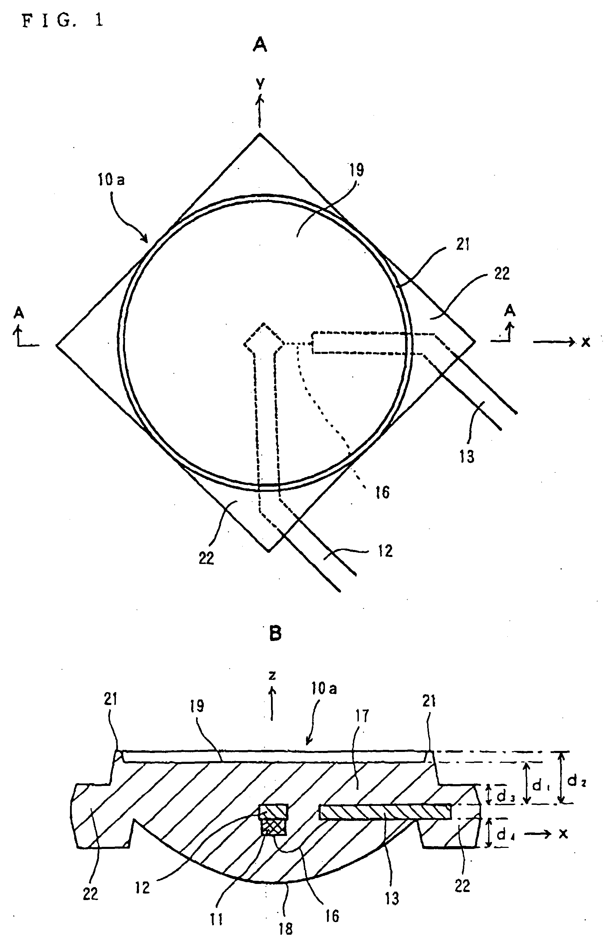

The first embodiment of the present invention will hereinafter be described with reference to the drawings. FIG. 1A is a schematic front view illustrating a reflection type light-emitting diode according to a first embodiment of the present invention. FIG 1B is a schematic cross-sectional view of the reflection type light-emitting diode taken along the line A - A in FIG. 1A.

Referring to FIGS. 1A and 1B, a reflection type light-emitting diode 10a comprises a light-emitting element 11, a first lead assembly 12, a second lead assembly 13, a bonding wire 16, a light-transmissible material 17, a concave reflection surface 18, a radiation surface 19, a protruded portion 21 and a lead deriving portion 22. In FIG. 1, the z-axis represent the center axis direction of the concave reflection surface 18, and the x-axis and the y-axis represent the orthogonal coordinate axes on the plane including the light-emitting surface of the light-emitting element 11. In the following description, the reflection type light-emitting diode will be simply referred to as "light-emitting diode".

The first lead assembly 12 and the second lead assembly 13 are adapted to supply electric power to the light-emitting element 11. The light-emitting element 11 is mounted on one end of the first lead assembly 12, and the light-emitting element 11 and the second lead assembly 13 are electrically interconnected with each other by the bonding wire 16. The light-emitting element 11, the tip end portions of the first load assembly 12 and the second lead assembly 13 and the bonding wire 16 are integrally sealed with the light-transmissible material 17 by transfer molding, for example. The light-transmissible material 17 might be a thermosetting resin, e.g. a transparent-epoxy resin whose refractive index is 1.5.

With respect to the light-transmissible material 17, not only its thickness on the concave reflection surface 18 side opposing the lead assemblies 12, 13 but also its thickness on the radiation surface side 19 opposing the lead assemblies 12, 13 should be selected in such a manner that the light-transmissible material 17 can completely cover the upper sides of the lead assemblies 12, 13. To be concrete, the lead assemblies 12, 13 should preferably be completely covered at their portions opposing the radiation surface 19 side by the light-transmissible material 17 and a distance $d_1$ between the surface of the lead assemblies 12, 13 opposing the radiation surface 19 side and the radiation surface 19 should preferably be selected to be at least 0.3 mm. The reason for this will be described below. That is, if the thickness between the lead assemblies 12, 13 and the radiation surface 19 is small, the upper sides of the lead assemblies 12, 13 will not be covered with the light-transmissible material 17 sufficiently because the characteristics of the light-transmissible material 17 are fluctuated by the lot in the fabrication. If the lead assemblies 12, 13 are exposed, then a crack tends to occur between the lead assemblies 12, 13 and the light-transmissible material 17. When the crack thus produced reaches the light-emitting element 11, an efficiency in which light is emitted is lowered, and a moisture-proof property and a weather-proof property of the light-emitting element 11 cannot be maintained. Also, it is useless that the light-emitting element 11 should be sealed by the light-transmissible material 17.

The concave reflection surface 18 is produced by mirror-grinding one surface of the light-transmissible material 17 according to a suitable method such as plating or metal vapor deposition, and is formed on the side opposing the light-emitting surface of the light-emitting element 11. Here, the concave reflection surface 18 is shaped like approximately a paraboloid of revolution having a focal point at which the center of the light-emitting surface of the light-emitting element 11 is disposed.

The radiation surface 19 is produced by forming the other surface of the light-transmissible material 17 in a flat-surface fashion, and is located at the position near the lead assemblies 12, 13 at the rear side of the light-emitting element 11. More precisely, the surface of the light transmissible material 17, equivalent to the optical path diameter of light reflected on the concave reflection surface 18, at the rear side of the light-emitting element 11 is the radiation surface 19. The diameter of the radiation surface 19 is about 5 mm. This radiation surface 19 and the light-emitting surface of the light-emitting element 11 are made approximately parallel to each other. As described above, in the first embodiment, the, position of the light-emitting element 11 and the shapes of the concave reflection surface 18 and the radiation surface 19 are designed such that the light-emitting diode 10a becomes able to emit parallel light.

Even though the light-emitting diode is designed such that it may emit parallel light and the optical surface thereof is formed as it is designed to be, in actual practice, the light-emitting portion of the light-emitting element is large to some extent, and it is unavoidable that an optical beam is spread. The size of the light-emitting portion should be reduced in order to suppress the spread of this optical beam to be small. To this end, there is generally used a current-confinement-type light-emitting element. When the current-confinement-type light-emitting element is in use, in order to effect the optical control with a high accuracy as compared with the case in which ordinary light-emitting elements are in use, it is requested that the concave reflection surface and the radiation surface should be formed with a high stability.

When a light-emitting element, such as the current-confinement-type light-emitting element, in which light is produced from one point of the light-emitting surface of the light-emitting element is in use, it is sufficient that the concave reflection surface 18 may be accurately shaped as a paraboloid of revolution. However, in the ordinary light-emitting element in which an electrode is formed at the center portion of the light-emitting surface of the light-emitting element end in which light is produced from other portion then the center portion of the light-emitting surface, if the concave reflection surface 18 is accurately shaped as the paraboloid of revolution, then light cannot be converted into parallel light strictly, thereby resulting in a problem. Therefore, in the ordinary light-emitting element in which light is produced from other portion than the center portion of the light-emitting surface, this problem can be effectively solved by a shape approximate to the paraboloid of revolution that is produced by affecting a very small deformation corresponding to the light-emitting pattern of the light-emitting element on the above-mentioned accurate paraboloid of revolution. For this reason, the shape of the concave reflection surface 18 has been so far referred to as "approximately paraboloid of revolution".

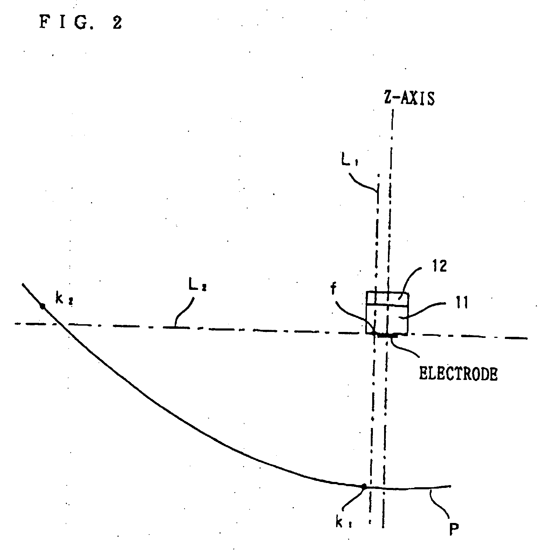

When the ordinary light-emitting element 11 which emits light from other portion than the center portion of the light-emitting surface is in use, such shape of approximately paraboloid of revolution will be concretely determined as follows. Specifically, as shown in FIG. 2, f assumes a point on the light-emitting surface of the light-emitting element 11 and which is located at other portion than the portion in which the electrode is formed. Then, let us assume a parabola P using the point f as a focal point. Also, $k_1$ assumes a point passing the point f and which is located in the vicinity of an intersection point between a straight line $L_1$ parallel to the z-axis and the parabola P. Moreover, $k_2$ assumes a point passing the point f and which is located in the vicinity of an intersection point, of two intersection points between a straight line $L_2$ perpendicular to the z-axis and the parabola P, on the side in which the point f is located on the z-axis. At that time, a curved surface obtained when the portion of the parabola P between the points $k_1$ and $k_2$ is rotated around the z-axis becomes a target shape of approximately paraboloid of revolution.

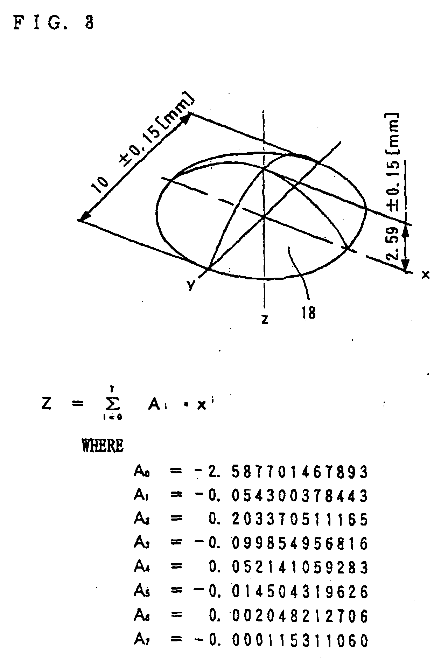

Further, the shape of such approximately paraboloid of revolution may be determined based on the simulated results obtained by using a computer. Specifically, as shown in FIG. 3, on the plane (e.g. z - x plane) including the center axis of the concave reflection surface 18, a plurality of points, e.g. 8 points on the concave reflection surface 18 are obtained in such a manner that light reflected on the concave reflection surface 18 after it was emitted from the light-emitting element 11 may become parallel light. Then, there are determined coefficients ($A_0$, $A_1$, ..., $A_7$) of a septimal equation: $z = A_0 + A_1 x + A_2 x^2 + A_3 x^3 + A_4 x^4 + A_5 x^5 + A_6 x^6 + A_7 x^7$ which passes the eight points thus obtained. For example, the respective coefficients are given as:

$A_0$ = -2.587701467893
$A_1$ = -0.054300378443
$A_2$ = 0.203370511165
$A_3$ = -0.099854956816
$A_4$ = 0.052141059283
$A_5$ = -0.014504319626
$A_6$ = 0.002048212706
$A_7$ = -0.000115311060

A curved surface obtained by rotating the equation thus determined about the z-axis becomes the shape of the concave reflection surface 18. A light-emitting diode in which the shape of the concave reflection surface is determined based on the septimal equation having the above-mentioned coefficients will hereinafter be referred to as a light-emitting diode $D_1$. FIG.3 shows the case in which the diameter of the radiation surface is about 10 mm.

The protruded portion 21 is formed around the radiation surface 19 so as to be protruded from the radiation surface 19. Here, the protruded portion 21 is formed around the whole of the radiation surface 19 in an annular fashion. In the first embodiment, the distance $d_1$ between the surface of the lead assemblies 12, 13 opposing the radiation surface 19 side and the radiation surface 19 is 1 mm, and a distance $d_2$ between the surface of the lead assemblies 12, 13 opposing the radiation surface 19 side and the tip end of the protruded portion 21 is 1.2 mm.

The lead deriving portion 22 is formed around the outsides of the concave reflection surface 18 and the radiation surface 19 to lead the lead assemblies 12, 13 to the outside. As the lead deriving portion 21, considering the strength in which the lead assemblies 12, 13 are bent or cut, the thickness of the light-transmissible material 17 on both the upper and lower sides of the lead assemblies 12, 13 is selected to be a proper value. For example, a distance $d_3$ between the surface of the lead assemblies 12, 13 opposing the radiation surface 19 side and the upper surface of the lead deriving portion 22 is selected to be 0.4 mm, and a distance $d_4$ between the surface of the lead assemblies 12, 13 opposing the concave reflection surface 18 side and the lower surface of the lead deriving portion 22 is selected to be 0.5 mm.

The radiation surface 19 and the protruded portion 21 are protruded from the lead deriving portion 22. The reason for this will be described below. The light-emitting diode 10a is attached to a jig such as a front plate. In this case, the front plate has a hole previously formed at its position in which the light-emitting diode 10a is disposed. Then, by fitting the radiation surface 19 thus protruded and the protruded portion 21 into such hole, it is possible to dispose the light-emitting diode 10a in the predetermined direction and at the predetermined position accurately with ease.

In the resin molding, injection molding is used most frequently. The injection molding uses a thermoplastic resin and fills the thermoplastic resin into the molding die under high pressure. At that time, even when the layer is produced into the molding die by the remaining air, such layer can be crushed by the pressure. Therefore, a concavity, such as a sink mark, is not produced on the surface of the resin molded product by the layer formed by the remaining air. However, the injection molding cannot be used when the lens type light-emitting diode or the reflection type light-emitting diode is molded by resin. The reason for this is as follows. That is, the lens type light-emitting diode or the reflection type light-emitting diode is generally made of a thermosetting epoxy resin having characteristics in which the light-emitting element is not damaged, the transparency is nigh and in which the refractive index is high. Also, when the lens type light-emitting diode or the reflection type light-emitting element is molded by resin, in order to prevent the bonding wire from being disconnected, there should be used a resin having a low viscosity, and the resin injection speed should be decelerated. Under such circumstances, when the lens type light-emitting diode or the reflection type light-emitting diode is molded by resin, there are generally available two methods of potting molding and transfer molding. In particular, since the reflection type light-emitting diode should form both the reflection surface and the radiation surface, there is used the transfer molding. When the reflection type light-emitting diode is produced by this transfer molding, if the resin injection pressure increases, than the resin is leaked from the clearance between the molding dies because the resin used therein is low in viscosity. Accordingly, the resin injection pressure cannot increase, and there arises the problem of the layer formed by the remaining air. The main theme of the present invention is to solve this problem.

As mentioned above, the light-emitting diode 10a is produced by using transfer molding. In the transfer molding, the molding die in which the accuracy of the shape is requested most is used as the lower molding die. The reason for this is that the problem of the remaining air layer does not arise in the lower molding die, and hence the concave reflection surface can be produced with exactly the same shape as that of the lower molding die. In the reflection type light-emitting diode, in order for the concave reflection surface to control light from the light-emitting diode, the concave reflection surface is molded by the lower molding die and the radiation surface is molded by the upper molding die. The upper and lower molding dies are manufactured based on the shapes designed with respect to the light-emitting diode. Moreover, a plurality of light-emitting diodes can he simultaneously produced by using a set of transfer molding dies.

The reason that the concave reflection surface is formed by the lower molding die and the radiation surface is formed by the upper molding die will be described in detail. When a resin is injected into the molding die in actual practice, initially, a resin is injected into the lower molding die under the condition that its viscosity is low. Then, after the resin fills the lower molding die completely, the resin is injected into the upper molding die. However, since the resin used is a thermosetting resin, once heated, the resin is hardened as time elapses. As a consequence, the resin obtained when it is injected into the upper molding die has a high viscosity as compared with the resin obtained when it is injected into the lower molding die. Therefore, the optical surface molded by the lower molding die into which the resin is injected under the condition that its viscosity is low has an excellent molding accuracy and may be produced with exactly the same shape as that of the lower molding die.

Although light emitted from the light-emitting element is reflected on the reflection surface, if the inclination of the reflection surface is shifted from a designed value due to a manufacturing error, then the reflection angle on the reflection surface is shifted twice as much as the shifted angle of the reflection surface. Light reflected on this reflection surface is refracted on the radiation surface and radiated to the outside. At that time, if an angle of light incident on the radiation surface is sufficiently small, then the refraction angle on the radiation surface becomes an angle which results from multiplying the incident angle by the refractive index (1.5). In particular, if the angle of light incident on the radiation surface is large, then the refraction angle on the radiation surface becomes greater than 1.5 times the incident angle. Therefore, if the center axis of the reflection surface is shifted by 1°, then the radiation angle in actual practice is shifted in excess of 3°. On the contrary, when the reflection surface is formed accurately, and the inclination of the radiation surface is shifted from a design value, the refraction angle on the radiation surface becomes an angle which results from multiplying the shifted angle on the radiation surface by the refractive index (1.5) so that a net shifted angle becomes 0.5 times the shifted angle of the radiation surface. Therefore, if the center axis of the radiation surface is shifted by 1°, then the radiation angle in actual practice is shifted by 0.5°. As described above, the molding accuracy of the reflection surface affects considerably the manner of controlling the radiation of light to the outside as compared with the molding accuracy of the radiation surface. For this reason, the reflection surface should be manufactured with a high accuracy as compared with the radiation surface.

From the above-mentioned reason, the reflection surface is formed by the lower molding die, and the radiation surface is formed by the upper molding die. However, even though the reflection surface and the radiation surface are formed as described above, there still remains the problem of the air layer left on the radiation surface. This problem becomes remarkably serious particularly when the reflection type light-emitting diode presents its characteristics, i.e. rays of light are optically controlled with a high accuracy while the external radiation efficiency is being improved.

When the light-emitting diode 10a is manufactured, a product in which the light-emitting element is mounted on the lead frame is sandwiched by the upper molding die and the lower molding die. Here, the lower molding die has previously formed thereon a recess to attach the lead frame such that the surface in which the upper molding die and the lower molding die contact with each other may be in flush with the upper surface of the lead frame. Then, a transparent epoxy resin is injected into a space formed between the upper molding die and the lower molding die. At that time, by adjusting an injection rate of resin, the molding conditions are set in such a manner that the resin may be filled into the upper molding die and the lower molding die before the resin is hardened. In the first embodiment, since the annular protruded portion 21 is formed around the radiation surface 19, an air remaining on the upper surface of the upper molding die is escaped in the upper direction and collected in the upper molding die at its portion opposing the annular protruded portion 21. As a consequence, an air layer is not left in the upper molding die at its portion opposing the radiation surface 19 so that the radiation surface 19 can be accurately formed with exactly the same shape as that of the upper molding die. Then, after the pressure of the resin injected into the space formed between the upper molding die and the lower molding die is increased and the resin is hardened while the increased resin pressure is held at the constant level, a molded product is ejected from the upper molding die and the lower molding die. Thereafter, undesired portions of the lead frame are removed by cutting and the lead assemblies 12, 13 are bent in the concave reflection surface 18 side, thereby resulting in the light-emitting diode 10a being obtained.

In the light-emitting diode 10a thus arranged, when the light-emitting element 11 is energized, the light-emitting element 11 is excited to produce light. Light produced from the light-emitting element 11 is reflected on the concave reflection surface 18 and then radiated from the radiation surface 19 to the outside. In particular, since the concave reflection surface 18 is of approximately the paraboloid of revolution and the center of the light-emitting surface of the light-emitting element 11 is disposed at its focal point, light passed through the radiation surface 19 is radiated to the outside as light parallel to the z-axis. Light produced from the light-emitting element 11 is once reflected on the concave reflection surface 18 and then radiated to the outside as described above, whereby light emitting from the light-emitting element 11 can effectively be radiated to the front. Therefore, the light-emitting diode 10a has characteristics that it is high in external radiation efficiency and high luminance/high luminous intensity. In addition, since light emitted from the light-emitting element 11 is controlled only by the concave reflection surface 18, the irradiation distribution of the light-emitting diode 10 itself has no deviated irradiation patterns and the degree of the uneven irradiation is small, thereby making it possible to improve a uniformity ratio of illuminance.

In the light-emitting diode according to the first embodiment, since the annular protruded portion that is protruded from the radiation surface is formed around the radiation surface and the concave reflection surface is molded by the lower molding die and the radiation surface is molded by the upper molding die according to transfer molding, when the molding die product is manufactured by transfer molding, an air remaining on the upper surface of the upper molding die is collected in the upper molding die at its portion opposing the annular protruded portion with the result that the air layer is not left in the upper molding die at its portion opposing the radiation surface. As a consequence, the radiation surface can be accurately produced with exactly the same shape as that of the upper molding die, so that the accuracy with which the radiation surface is molded can be improved. Thus, the problem of appearance can be solved, and the radiation characteristics on the radiation surface can be obtained as they are wanted to be in the design. Moreover, since the concave reflection surface is formed by the lower molding die, there does not arise the problem of the remaining air layer with respect to the concave reflection surface, and hence the concave reflection surface can be accurately produced with exactly the same shape as that of the lower molding die.

Although an air which remains on the upper surface of the upper molding die is left in the protruded portion to affect the shape of the protruded portion, portions other than the optical surface are generally formed as the lacquer ware with a flecked effect, so that the problem of appearance such as when concavities are produced on the flat surface can be solved. Furthermore, since the protruded portion does not affect the radiation characteristics, there does not arise any problem.

From a theory standpoint, the reflection type light-emitting diode has a characteristic such that it can radiate light to the front with high efficiency. Having been compared with the lens type light-emitting diodes, the reflection type light-emitting diode of the type for emitting parallel light has a radiation efficiency about three times as high as the lens type light-emitting diode, and the reflection type light-emitting diode of the type for converging light at one point has a radiation efficiency more than three times as high as the lens type light-emitting diode. However, the reflection type light-emitting diode has restrictions from a structure and manufacturing standpoint unlike the lens type light-emitting diode. For this reason, heretofore, the reflection type light-emitting diodes of the mass-produced level products would not have such theoretical radiation characteristics. Because the reflection type light-emitting diode according to the first embodiment is produced by the above-mentioned manufacturing method, this reflection type light-emitting diode can obtain excellent characteristics from a theory standpoint, and is excellent from a mass-production standpoint.

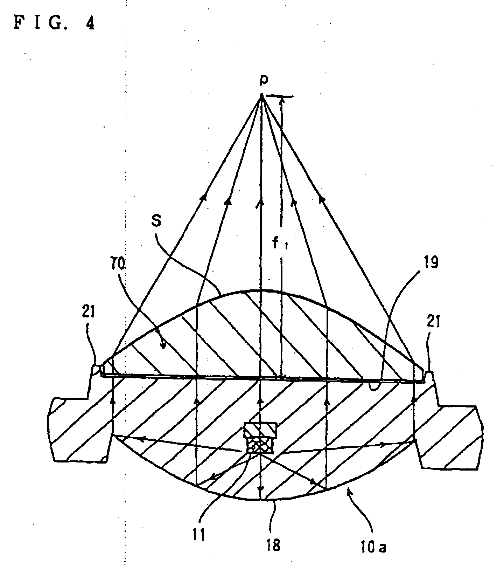

If the parallel light deriving-type light-emitting diode 10a according to the first embodiment uses a condenser lens 70 whose one surface is made flat an shown in FIG. 4, for example, together, then there can be obtained a condenser type light-emitting diode. Since the parallel light deriving-type light-emitting diode 10a can effectively utilize light emitted from the light-emitting element 11, it can increase a quantity of light and can radiate parallel light with high accuracy. As a consequence, the condenser lens 70 condenses light radiated from such parallel light deriving-type light-emitting diode 10a, so that the condenser type light-emitting diode shown in FIG. 4 has characteristics such that it is high in condensing accuracy and high in irradiation density. In addition, since the protruded portion 21 can be used as a portion with which the condenser lens 70 is engaged, there is then the advantage that, when the parallel light deriving-type light-emitting diode 10a and the condenser lens 70 are bonded together, the center axis of the parallel light deriving-type light-emitting diode 10a and the center axis of the condenser lens 70 can be easily made coincident with each other with a high accuracy.

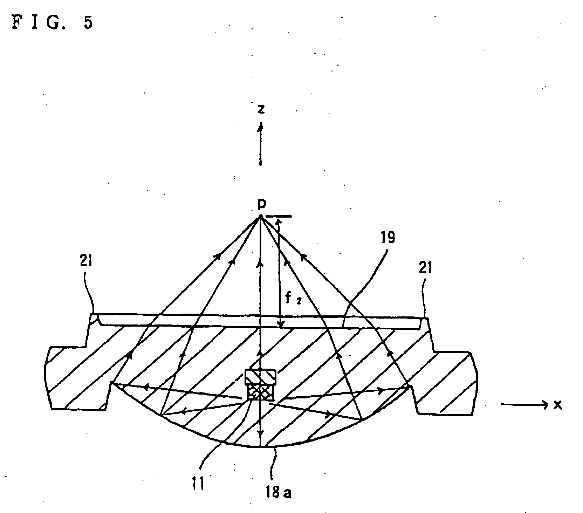

While the concave reflection surface is shaped like approximately the paraboloid of revolution according to the first embodiment as described above, the present invention is not limited thereto, and the following variant is also possible. That is, as shown in FIG. 5, for example, the radiation surface 19 is made planar similarly to the first embodiment, and a concave reflection surface 18a is shaped in such a fashion that light that was reflected on the concave reflection surface 18a after it had been emitted from the light-emitting element 11 is refracted on the radiation surface 19 and then condensed at one point. Thus, the condenser type light-emitting diode may be provided without using the lens together. In this case, since a refraction phenomenon occurs on the radiation surface 19, if the concave reflection surface 18a had been shaped as an ellipsoid of revolution, light would not be condensed at one point. To determine the shape of the concave reflection surface 18a, such shape may be determined based on results obtained by the simulation using a commuter. Specifically, a plurality of points, e.g. eight points on the concave reflection surface 18a are calculated in such a manner that, with respect to the plane (e.g. z - x plane including the center axis (z-axis) of the concave reflection surface 18a, light reflected on the concave reflection surface 18a after it has been emitted from the light-emitting element 11 may be refracted on the radiation surface 19 and condensed at one point. Then, there are determined coefficients ($B_0$, $B_1$, ..., $B_7$) of a septimal equation $z = B_0 + B_1 x + B_2 x^2 + ... + B_7 x^7$ which passes the eight point thus obtained. A curved surface which results from rotating the equation thus determined around the z-axis becomes the shape of the concave reflection surface 18a.

Let us compare the condenser type light-emitting diode shown in FIG. 4 and the condenser type light-emitting diode shown in FIG. 5. In resin lenses that are generally available, when an incident angle of light incident on a lens curved surface (e.g. an upper surface S of the condenser lens 70 of the condenser type light-emitting diode shown in FIG. 4 and the radiation surface 19 of the condenser type light-emitting diode shown in FIG. 5) which serves as the external radiation surface increases in excess of about 30°, an interface reflection increases and ineffective light that is not condensed at the focusing point P increases, so that an irradiation efficiency is lowered. Accordingly, in the condenser type light-emitting diode shown in FIG. 4 made by a combination of the parallel light deriving-type light-emitting diode 10a and the condenser lens 70, the shortest focal length $f_1$ (measured based on the standard of the radiation surface 19) in which light may be effectively irradiated under the condition that the incident angle falls within 30° is approximately the diameter of the concave reflection surface 18. On the other hand, in the light-emitting diode shown in FIG. 5 in which the concave reflection surface 18a is shaped such that light reflected on the concave reflection surface 18a after it has been emitted from the light-emitting element 11 may be refracted on the radiation surface 19 and then condensed at one point, the shortest distance $f_2$ (measured based on the standard of the radiation surface 19) in which light may be effectively irradiated under the condition that the incident angle falls within 30° becomes approximately the radius of the concave reflection surface 18a. That is, the condenser type light-emitting diode shown in FIG. 5 can reduce the shortest focal length in which light can be effectively irradiated by about 1/2 as compared with the condenser type light-emitting diode shown in FIG. 4.

When the incident angle of light incident on the lens curved surface which serves as the external radiation surface is selected to be greater than 30°, the interface reflection loss increases. Even in this case, when it is requested that the irradiation density should be maximized at the focusing point P, the focal length should further preferably be reduced. When the focal length is reduced as described above, if the incident angle is shifted due to the displacement of the angle of the center axis of the radiation surface, for example, then the displacement of the radiation angle relative to the displacement of the incident angle increases, so that the displacement of the irradiation position increases further. Therefore, the molding accuracy of the radiation surface is extremely important, and the radiation surface should be molded with a high accuracy.

When the condenser type light-emitting diode is fabricated, there are continuously an infinite number of combinations of the reflection surface and the radiation surface. Except the combination of the reflection surface and the planar radiation surface shaped such that light refracted on the radiation surface after it was reflected on the reflection surface may be condensed at one point, there is a combination of a reflection surface shaped as ellipsoid of revolution using a light emitting point and a condensing point as the focal point and a radiation surface shapes as a spherical surface using a focusing point as a center. According to the latter combination, since light reflected on the reflection surface becomes incident on the radiation surface in the vertical direction, influences of interface reflection loss and displacement of radiation angle relative to the displacement of incident angle are small. Thus, the focal length can be set at the shortest range from the radiation surface.

However, in the actual manufacturing, there is a tolerance of several 10s of micrometers between the center axis of the reflection surface and the center axis of the radiation surface. Consequently, even through the light-emitting diode formed by the combination of the reflection surface of the ellipsoid of revolution shape and the radiation surface of spherical surface shape is manufactured, it is not always possible to effect the optical control as it is wanted to be in the design. In particular, in the light-emitting diode having the short focal length, the influence exerted upon the radiation characteristic by the shift of parallel axes becomes remarkable. Considering such point, although the combination of the reflection surface of approximately paraboloid of revolution shape, the planar radiation surface and the condenser lens like the light-emitting diode shown in FIG. 4 and the combination of the reflection surface shaped such that light refracted on the radiation surface after it was reflected on the reflection surface is condensed at one point and the planar radiation surface like the light-emitting diode shown in FIG. 5 have a tolerance of several 10s of micrometers between the center axis of the reflection surface and the center axis of the radiation surface, the radiation characteristics can be prevented from being affected and the stable radiation characteristics can be obtained. Also the molding dies can be manufactured with ease, and hence it is to be appreciated that such combinations are desirable combinations in actual practice.

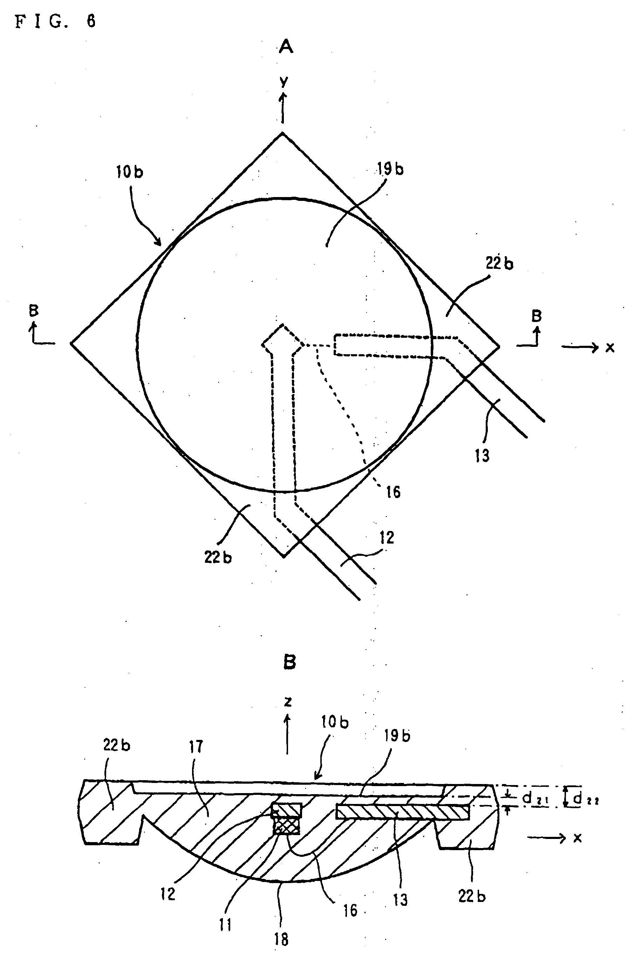

A second embodiment according to the present invention will be described next with reference to the drawings. FIG. 6A is a schematic front view of a reflection type light-emitting diode according to a second embodiment of the present invention. FIG. 6B is a schematic cross-sectional view of the reflection type light-emitting diode taken along the line B - B in FIG. 6A. In the second embodiment, elements and parts having the functions identical to those of the first embodiment are marked with same reference numerals, and therefore need not be described in detail.

As shown in FIGS. 6A and 6B, a light-emitting diode 10b comprises the light-emitting element 11, the first lead assembly 12, the second lead assembly 13, the bonding wire 16, the light-transmissible material 17, the concave reflection surface 18, a planar radiation surface 19b and a lead deriving portion 22b. The light-emitting diode 10b according to the second embodiment differs from that of the first embodiment in that the radiation surface 19b is recessed from the lead deriving portion 22b by reducing the portion of the radiation surface 19b at its portion above the lead assemblies 12, 13 while the thickness of the lead deriving portion 22b above the lead assemblies 12, 13 is not changed. That is, the lead deriving portion 22b is protruded from the radiation surface 19b, and this lead deriving portion 22b can be served as the protruded portion 21 of the first embodiment. This light-emitting diode 10b is in use when it is held by the surrounding portion of the reflection surface or when it need not be attached to a jig such as a front plate.

In accordance with the second embodiment, a distance $d_{22}$ between the surface of the lead assemblies 12, 13, for example, opposing the radiation surface 19b side and the upper surface of the lead deriving portion 22b is selected to be 0.4 mm, and a distance $d_{21}$ between the surface of the lead assemblies 12, 13 opposing the radiation surface 19b side and the radiation surface 19b is selected to be 0.3 mm.

In such light-emitting diode 10b, the concave reflection surface 18 is produced by the lower molding die and the radiation surface 19b is produced by the upper molding die according to transfer molding similarly to the first embodiment.

Even in the light-emitting diode according to the second embodiment, since the lead deriving portion (protruded portion) protruded from the radiation surface is formed around the radiation surface, the concave reflection surface is produced by the lower molding die and the radiation surface is produced by the upper molding die according to transfer molding, similarly to the first embodiment, the radiation surface can be produced with exactly the same shape as that of the upper molding die, accordingly, the molding accuracy of the radiation surface may be improved. Thus, not only the problem of the appearance can be solved but also the radiation characteristic on the radiation surface can be obtained as it is wanted to become in the design. In particular, in the light-emitting diode according to the second embodiment, since the radiation surface is recessed from the lead deriving portion, the distance between the radiation surface and the upper surface of the lead assembly can be reduced as compared with the light-emitting diode of the first embodiment so that a volume of a molding die space produced by the upper molding die can be decreased. As a consequence, a quantity of remaining air collected in the upper molding die can be decreased, and the problem of the remaining air layer can be alleviated.

Also, in the second embodiment, the thickness of the lead deriving portion is properly selected such that a sufficient strength required when the lead assembly is bent or cut may be obtained. In addition, the thickness of the portion of the radiation surface above the upper side of the lead assembly is reduced relative to the thickness of the lead deriving portion above the upper side of the lead assembly. Therefore, it is possible to obtain the thinnest reflection type light-emitting diode in which the optical surface is shaped with a high accuracy.

Further, in the second embodiment, since the radiation surface is recessed from the lead deriving portion, the distance between the radiation surface and the light-emitting surface of the light-emitting element and the upper surface of the lead assembly can be made shorter than that of the first embodiment, thereby making it possible to improve the heat radiation property. That is, heat generated from the light-emitting element can be radiated not only through the lead assembly to the outside but also a large quantity of heat can be radiated to the outside through the light-transmissible material from the radiation surface. Therefore, the light-emitting diode according to the second embodiment is suitable for use in the case where a light-emitting element which is easily damaged by heat, where a power consumption is large when a large output is requested and where a light-emitting diode arrangement is formed by densely mounting a plurality of light-emitting diodes on the substrate and such light-emitting diode arrangement needs a path for radiating heat to the outside.

Also in the light-emitting diode according to the second embodiment, the radiation surface may be shaped as a planar surface and the concave reflection surface may be shaped such that light that was reflected on the concave reflection surface since it had been emitted from the light-emitting element is refracted on the radiation surface and condensed at one point. Thus, there can be obtained a condenser type light-emitting diode. A magnification $m$ of an image of a light-emitting element is determined by an optical distance $h_2$ from the concave reflection surface to the focusing point relative to an optical distance $h_1$ from the light-emitting element to the concave reflection surface ($m = h_2/h_1$). In the light-emitting diode according to the second embodiment, the thickness of the light-transmissible material having a large refractive index can be reduced by reducing the distance between the light-emitting surface of the light-emitting element and the radiation surface. Accordingly, the light-emitting diode in which the light-emitting diode according to the second embodiment is comprised of the condenser type can reduce the optical distance from the concave reflection surface to the focusing point as compared with the light-emitting diode in which the light-emitting diode according to the first embodiment shown in FIG. 5 is comprised of the condenser type. Therefore, since the light-emitting diode in which the light-emitting diode according to the second embodiment is comprised of the condenser type can further reduce the magnification of the image of the light-emitting element, it can increase the light radiation density as compared with the light-emitting diode of the condenser type (FIG. 5) according to the first embodiment.

A distance $d_{21}$ between the surface of the lead assemblies 12, 13 opposing the radiation surface 19b side and the radiation surface 19b may be less than 0.3 mm. At that time, there is then the risk that a yield of products will be lowered due to fluctuations of characteristics of the manufacturing lot of the light-transmissible material 17 used. As the light-transmissible material 17, it is desirable to select such a light-transmissible material having a specific characteristic such that it can cover the upper sides of the lead assemblies 12, 13 even when the thickness between the lead assemblies 12, 13 and the radiation surface 19b is small. Moreover, from a standpoint of a strength required when the lead assemblies 12, 13 are bent and cut, a distance $d_{22}$ between the surface of the lead assemblies 12, 13 opposing the radiation surface 19b side and the upper surface of the lead deriving portion 22b should be selected to be approximately 0.4 mm in actual practice. In these cases, as a result, the protruded portion protruded from the radiation surface 19b is formed around the radiation surface 19b.

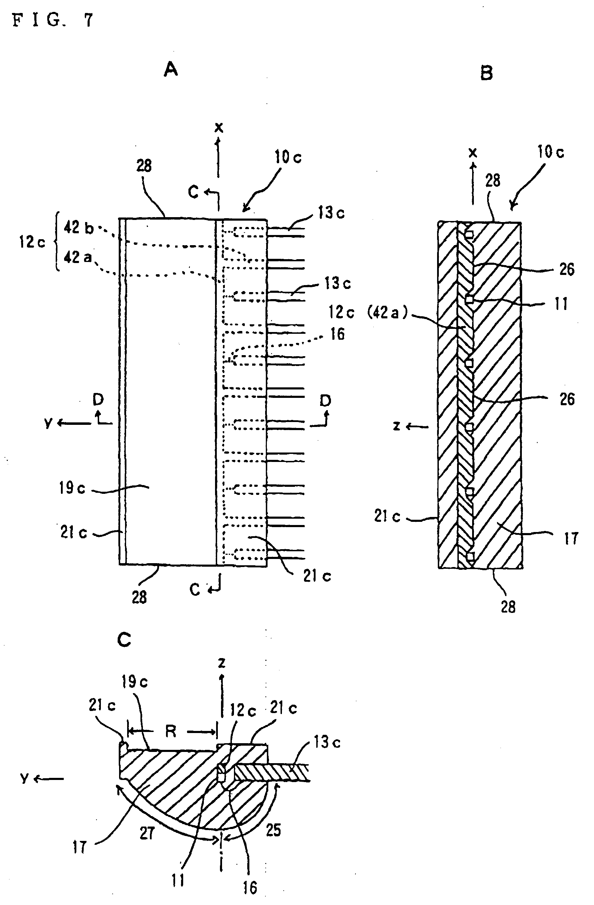

Next, a third embodiment according to the present invention will be described with reference to the drawings. FIG. 7A is a schematic front view of a reflection type light-emitting diode according to the third embodiment of the present invention. FIG. 7B is a schematic cross-sectional view of the reflection type light-emitting diode teen along the line C - C in FIG. 7A. FIG. 7C is a schematic cross-sectional view of the reflection type light-emitting diode taken along the line D-D in FIG. 7A. In the third embodiment, elements and parts having functions identical to those of the first embodiment are marked with the same reference numerals, and therefore need not be described in detail.

As shown in FIGS. 7A, 7B and 7C, a light-emitting diode 10c according to the third embodiment comprises a plurality of light-emitting elements 11, a first lead assembly 12c, a plurality of second lead assemblies 13c, a plurality of bonding wires 16, the light-transmissible material 17, a radiation surface 19c, a protruded portion 21c, a first concave cylinder reflection surface 25, an intermediate reflection surface 26, a second concave cylinder reflection surface 27 and a side reflection surface 28. A plurality of light-emitting elements 11 are rectilinearly arrayed with a constant interval under the condition that their light-emitting surfaces are directed to the under side as shown in FIG. 7C. In FIG. 7C, the x-axis represents the direction in which the light-emitting elements 11 are arrayed, the y-axis represents the direction perpendicular to the x-axis on the plane including the light-emitting surface of the light-emitting element, and the z-axis represents the direction perpendicular to the x-axis and the y-axis.

The first lead assembly 12c and the second lead assembly 13c are adapted to supply electric power to the light-emitting element 11. As shown in FIG. 7A, the first lead assembly 12c includes an x-direction lead assembly 42a disposed along the x-axis direction and a plurality of y-direction lead assemblies 42b, disposed along the y-axis direction with a constant interval, connected to the x-direction lead assembly 42a. A plurality of second lead assemblies 13c are disposed between the two y-direction lead assemblies 42b along the y-axis direction. The second lead assembly 13c is provided at every light-emitting element 11. These y-direction lead assembly 42b and the second lead assembly 13c are both led out to the outside from the side of the first concave cylinder reflection surface 24. The first lead assembly 12c and the second lead assembly 13c are made of metals such as copper alloy and iron alloy, and the surfaces of the first lead assembly 12c and the second lead assembly 13c are plated by silver.

A plurality of light-emitting elements 11 are mounted on the x-direction lead assembly 42a of the first lead assembly 12c. To be concrete, each mount for mounting the light-emitting element 11 is located at substantially intermediate position of the two adjacent connecting portion where the y-direction lead assembly 42b is connected to the x-direction lead assembly 42a. Also, the mount is made thinner than other portion by the height of the light-emitting element 11 as shown in FIG. 7B. That is, the light-emitting surface of the light-emitting element 11 mounted an the mount is flush with the surface other than the mount of the x-direction lead assembly 42a. The tip end of each second lead assembly 13c is disposed near the mount, and the light-emitting element 11 and the second lead assembly 13c are electrically interconnected with each other by the bonding wire 16. Moreover, the light-emitting element 11, a part of the first lead assembly 12c, the tip end of the second lead assembly 13c and the bonding wire 16 are integrally sealed by the light-transmissible material 17.

In the above-mentioned light-emitting diode 10c, each light-emitting element is energized by a parallel circuit, which becomes advantageous when a macroscopic continuous adjustment such as uneven illuminance between the x-direction peripheral portion and the central portion of the light-emitting diode 10c is conducted. Therefore, this limitation may not become a limitation, in particular, from a function standpoint.

The intermediate reflection surface 26 is disposed near the straight line on which a plurality of light-emitting elements 11 are arrayed between the two light-emitting elements 11. Here, as the intermediate reflection surface 26, there is utilized the surface of the x-direction lead assembly 42a of the first lead assembly 12c. That is, of the x-direction lead assembly 42a, the surface of the portion excepting the mount is the intermediate reflection surface 26. This intermediate reflection surface 26 is flush with the light-emitting surface of the light-emitting element 11. Although the intermediate reflection surface 26 is generally made of a material having a high reflectance, this intermediate reflection surface 26 may have a feature capable of either regularly reflecting light or irregularly reflecting light. In particular, it is desirable that this intermediate reflection surface 26 has a feature which is able to regularly reflect incident light to some extent and to irregularly reflect incident light to some extent. In the third embodiment, the intermediate reflection surface 26 is rendered such desirable feature by plating the first lead assembly 12c with silver.

The first concave cylinder reflection surface 25 and the second concave cylinder reflection surface 27 are produced by mirror-grinding the rear surface of the light-transmissible material 17 according to a suitable method such as plating and metal vapor deposition. The first concave cylinder reflection surface 25 and the second concave cylinder reflection surface 27 are formed on the light-emitting surface side of the light-emitting element 11. The center axes of the first concave cylinder reflection surface 25 and the second concave cylinder reflection surface 27 are made parallel to the arrangement direction (x-axis direction) of the light-emitting element 11, respectively. As shown in FIG. 7C, the first concave cylinder reflection surface 25 is formed on the right-hand side of the plane including the x-axis and which is perpendicular to the y-axis. The second concave cylinder reflection surface 27 is formed on the left-hand side of that plane.

The shape of the first concave cylinder reflection surface 25 is designed such that light emitted from the light-emitting element 11 and light reflected on the intermediate reflection surface 26 may be reflected on the straight line on which the light-emitting elements are arrayed. That is, the center axis of the first concave cylinder reflection surface 25 is made identical to the straight line on which the light-emitting elements 11 are arrayed, and the sectional face of the first concave cylinder reflection surface 25 taken along the y - Z plane is made circular. On the other hand, the sectional face of the second concave cylinder reflection surface 27 taken along the y - z plane is shaped as approximately a parabola using the light-emitting element 11 or the intermediate reflection surface 26 as a focal point in such a fashion that light emitted from the light-emitting element 11 placed within the y - z plane or light reflected on the intermediate reflection surface 26 may be reflected on the second concave cylinder reflection surface 27 and then vertically introduced into the radiation surface 19c.

The side reflection surface 28 is produced by mirror-grinding the side surfaces of the respective ends of the light-transmissible material 17 in the direction (x-axis direction ) in which the light-emitting elements 11 are arrayed similarly to the first concave cylinder reflection surface 25 and the second concave cylinder reflection surface 27. Also, the radiation surface 19c is produced by processing the front surface of the light-transmissible material 17 in a planar fashion and is disposed at the rear side of the light-emitting element 11. More precisely, a range R shown in FIG. 7C, i.e. the surface of the light-transmissible material 17, opposing the second concave cylinder reflection surface 27, at the rear side of the light-emitting element 11 is the radiation surface 19c. This radiation surface 19c and the light-emitting surface of the light-emitting element 11 are made approximately parallel to each other.

Around the radiation surface 19c in the y-axis direction of FIG. 7A, there is formed the protruded portion 21c protruded from the radiation surface 19c. In particular, the whole surface of the light-transmissible material 17, opposing the first concave cylinder reflection surface 25, at the rear side of the light-emitting element 11 is formed as the protruded portion 21c. Also, the protruded portion is not formed around the radiation surface 19c in the x-axis direction in FIG. 7A.

In such light-emitting diode 10c, similarly to the light-emitting diode according to the first embodiment, the concave cylinder reflection surface 18c is molded by the lower molding die and the radiation surface 19c is molded by the upper molding die according to transfer molding.

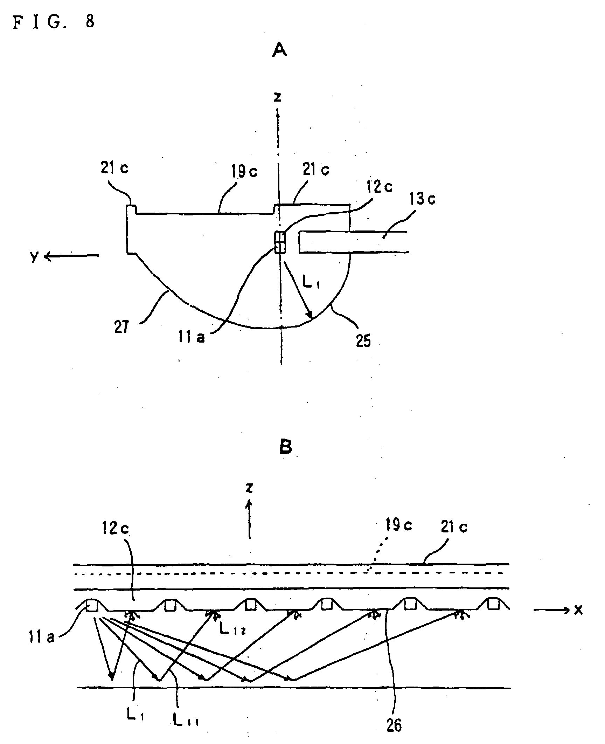

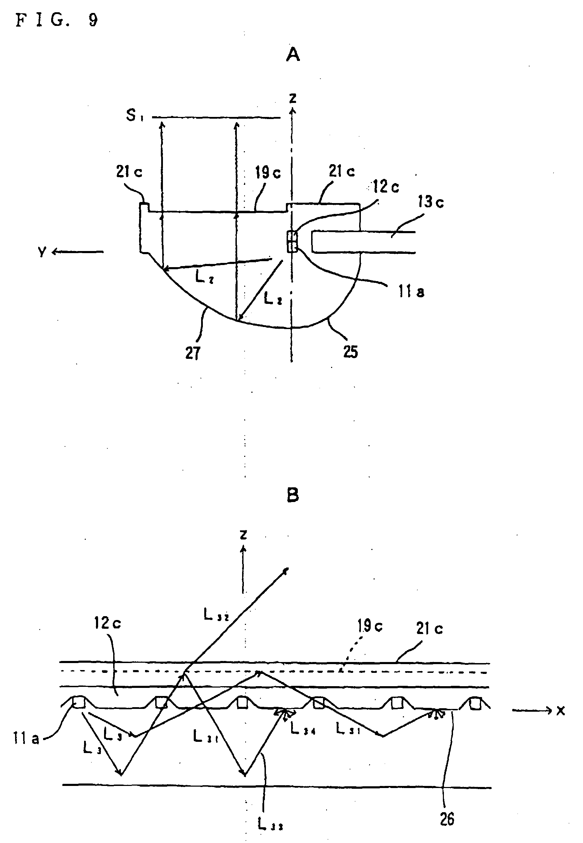

Next, an optical path of light emitted from the light-emitting element of the light-emitting diode 10c thus arranged will be described below. FIG. 8A is a diagram of an optical path of light within the y-z plane which becomes incident on the first cylindrical reflection surface after light was emitted from one of the light-emitting elements of the light-emitting diode 10c. FIG. 8B is a diagram showing an optical path of light within the plane including the x-axis which becomes incident on the first cylindrical reflection surface after light was emitted from one of the light-emitting elements of the light-emitting diode 10c. Also, FIG. 9A is a diagram showing an optical path of light within the y-z plane which becomes incident on the second cylindrical reflection surface after light was emitted from one of the light-emitting elements of the light-emitting diode. FIG. 9B is a diagram showing an optical path of light within the plane including the x-axis which becomes incident on the second cylindrical reflection surface after light was emitted from one of the light-emitting elements of the light-emitting diode 10C. Here, let us pay attention to light emitted from one of the light-emitting element 11a. In FIGS. 8A, 8B and FIGS. 9A, 9B, the light-emitting diode 10C is not shown hatched in order to understand the optical path of light more clearly.

Initially, when one light-emitting element 11a is energized, the light-emitting surface of the light-emitting element 11a emits light and light is radiated in all sorts of the directions whose angles relative to the center axis of the light-emitting surface fall within approximately 90°. At that time, of light emitted from the light-emitting element 11a, light $L_2$ incident on the second concave cylinder reflection surface 27 and which light was radiated into the y - z plane including the light-emitting element 11a is reflected in the direction parallel to the z-axis by the second concave cylinder reflection surface 27 and introduced into the radiation surface in approximately the vertical direction and thereby irradiated on the irradiated surface $S_1$ as parallel light as shown in FIG. 9A.

Also, of light emitted from the light-emitting element 11a, light $L_3$ incident on the second concave cylinder reflection surface 27 and which light was other than light radiated into the y - z plane including the light-emitting element 11a is reflected on the second concave cylinder reflection surface 27 and then introduced into the radiation surface 19c as shown in FIG. 9B. Light that became incident on this radiation surface 19c are light $L_{31}$ which will be reflected on the interface and light $L_{32}$ which will be radiated to the outside. When the refractive index of the light-transmissible material 17, for example, is 1.5, if the incident angle of light on the radiation surface 19c is small, then light which will be reflected on the interface is less than 5%. If the incident angle of light on the radiation surface 19c increases in excess of 30°, then a ratio of light which will be reflected on the interface becomes a ratio that cannot be neglected. Then, when the incident angle increases in excess of 42°, the incident angle exceeds a critical angle, so that whole light becomes light that will be interface-reflected.

Light $L_{32}$ that is radiated from the radiation surface 19c to the outside is refracted on the radiation surface 19c and irradiated on the irradiated surface $S_1$. On the other hand, light $L_{31}$ that was interface-reflected on the radiation surface 19c is reflected on the second concave cylinder reflection surface 27 and then becomes incident on the straight line on which the light-emitting elements are arrayed. Light $L_{33}$ that is to be introduced into the intermediate reflection surface 26 is irregularly reflected on the intermediate reflection surface 26 and travels toward the first concave cylinder reflection surface 25 and the second concave cylinder reflection surface 27. Here, since the intermediate reflection surface 26 is disposed between the two light-emitting elements along the straight line on which the light-emitting elements are arrayed, light that was reflected on the intermediate reflection surface 26 behaves as if it were light emitted from the light-emitting element. That is, the intermediate reflection surface 26 becomes a pseudo-light source. As a consequence, of light $L_{34}$ that was irregularly reflected on the intermediate reflection surface 26, light that became incident on the first concave cylinder reflection surface 25 is reflected on the first concave cylinder reflection surface 25 and become incident on the straight line along which the light-emitting elements are arrayed. On the other hand, of light $L_{34}$ that was irregularly reflected on the intermediate reflection surface 26, light that became incident on the second concave cylinder reflection surface 27 is again reflected on the second concave cylinder reflection surface 27 and then introduced into the radiation surface 19c.

Moreover, of light that was emitted from the light-emitting element 11a, light $L_1$ which becomes incident on the first concave cylinder reflection surface 25 is reflected on the first concave cylinder reflection surface 25 and then introduced into the straight line along which the light-emitting elements are arrayed. Light $L_{11}$ that becomes incident on the intermediate reflection surface 26 is irregularly reflected on the intermediate reflection surface 26 and travels toward the first concave cylinder reflection surface 25 and the second concave cylinder reflection surface 27 as shown in FIG. 8B. Since the intermediate reflection surface 26 becomes a pseudo-light source, of light $L_{12}$ that was irregularly reflected on the intermediate reflection surface 26, light that becomes incident on the first concave cylinder reflection surface 25 is reflected again on the first concave cylinder reflection surface 25 and then becomes incident on the straight line along which the light-emitting elements are arrayed. On the other hand, of light $L_{12}$ that was irregularly reflected on the Intermediate reflection surface 26, light that becomes incident on the second concave cylinder reflection surface 27 is reflected on the second concave cylinder reflection surface 27 and then introduced into the radiation surface 19c. As described above, light that becomes incident on this radiation surface 19c are light which will be interface-reflected and light which will be radiated to the outside. Light that will be interface-reflected is reflected on the second concave cylinder reflection surface 27 and then becomes incident on the straight line along which the light-emitting elements are arrayed. Also, light that will be radiated to the outside is refracted on the radiation surface 19c and irradiated on the irradiated surface $S_1$.

As described above, since the light-emitting diode 10c according to the third embodiment can effectively utilize light that was interface-reflected on the radiation surface 19c, it is possible to improve the external radiation efficiency. Further, light that was interface-reflected on the radiation surface 19c is again condensed by the second concave cylinder reflection surface 27 widely on the intermediate reflection surface 26 along the x-axis direction and irregularly reflected by the intermediate reflection surface 26. As a consequence, it is possible to considerably widen the illuminance distribution range of light emitted from each light-emitting element in the x-axis direction.

In the light-emitting diode according to the third embodiment, since the protruded portion that is protruded from the radiation surface is formed around the radiation surface, the concave cylinder reflection surface is molded by the lower molding die and the radiation surface is molded by the upper molding die according to transfer molding, similarly to the light-emitting diode according to the first embodiment, the radiation surface can be accurately produced with exactly the same shape as that of the upper molding die, thereby making it possible to improve the molding accuracy of the radiation surface. Therefore, the problem of appearance can be eliminated and the radiation surface can obtain the radiation characteristic as it is wanted to have in the design.

Further, since the light-emitting diode according to the third embodiment includes the first concave cylinder reflection surface which reflects light from the light emitting elements onto the straight line along which the light-emitting elements are arrayed and the intermediate reflection surface disposed between the two light-emitting element near the straight line on which the light-emitting elements are arrayed, the intermediate reflection surface becomes the pseudo-light source and the irradiation distribution of light emitted from each light-emitting element in the x-axis direction can cover the wide range, thereby making it possible to improve uniformity ratio of illuminance. Accordingly, even when the characteristic of one light-emitting element, for example, is inferior or readily deteriorated so that its output is considerably lowered as compared with those of other light-emitting elements, the lowered output of one light-emitting element can be covered by other light-emitting elements. Furthermore, even when the interval at which the light-emitting elements are arrayed is widened as compared with the related art, it is possible to obtain a similar uniformity ratio of illuminance.

Moreover, light radiated from the light-emitting element to the side of the first concave cylinder reflection surface is reflected on the first concave cylinder reflection surface and then introduced into the straight line along which the light-emitting elements are arrayed. Of light reflected on the first concave cylinder reflection surface, light which travels toward the side of the second concave cylinder reflection surface after it was reflected on the intermediate reflection surface is reflected on the second concave cylinder reflection surface and then radiated to the outside. Accordingly, light is radiated to the outside only from the range R shown in FIG. 7C and light is not radiated to the outside from the side in which the lead assembly is led out, thereby making it possible to prevent the irradiation intensity density from being made uneven by the lead assembly. Further, the lead assembly can shield light emitted from the light-emitting element, thereby making it possible to prevent the external radiation efficiency from being lowered. In addition, since the intermediate reflection surface is disposed between the two light-emitting elements near the straight line along which the light-emitting elements are arrayed, of light reflected on the intermediate reflection surface, light that becomes incident on the second concave cylinder reflection surface is controlled by the second concave cylinder reflection surface and irradiated on a predetermined irradiation area similarly to light radiated from the light-emitting element to the side of the second concave cylinder reflection surface, thereby making it possible to improve the irradiation intensity density.

Further, since the side reflection surfaces are provided on both side portions in the direction in which the light-emitting elements are arrayed, of light emitted from the light-emitting element and light reflected on the intermediate reflection surface, light that becomes incident on the side reflection surface is reflected on the side reflection surface and returned to the inside. As a result, such light also is radiated from the radiation surface and reaches the irradiated surface. Therefore, light reflected on the side reflection surface can be utilized effectively and it is possible to suppress the illuminance from being lowered at the end of the light-emitting diode.

According to the third embodiment, since the light-emitting element is sealed, by the light-transmissible material, although an efficiency at which light is emitted from the inside of the light-emitting element into the light-transmissible material can be increased, of light emitted from the light-emitting element, there exists light which is totally reflected on the radiation surface and is therefore not radiated to the outside. However, once light, having an angle at which it is totally reflected on the radiation surface, is introduced into the intermediate reflection surface, such light is reflected irregularly. Therefore, a part of such light can be radiated from the radiation surface to the outside, whereby the light-emitting efficiency can be improved.

The present invention is not limited to the light-emitting diode according to the third embodiment, and the following variant is also possible. That is, with respect to a light-emitting diode comprising a plurality of light-emitting elements arrayed rectilinearly, a concave cylinder reflection surface opposed to the light-emitting surfaces of a plurality of light-emitting elements, a radiation surface for radiating light reflected on the concave cylinder reflection surface to the outside and the protruded portion, protruded from the radiation surface, formed around the radiation surface, when the concave cylinder reflection surface is molded by the lower molding die and the radiation surface is molded by the upper molding die according to transfer molding, the radiation surface can be produced with exactly the same shape as that of the upper molding die, thereby making it possible to improve the molding accuracy of the radiation surface.

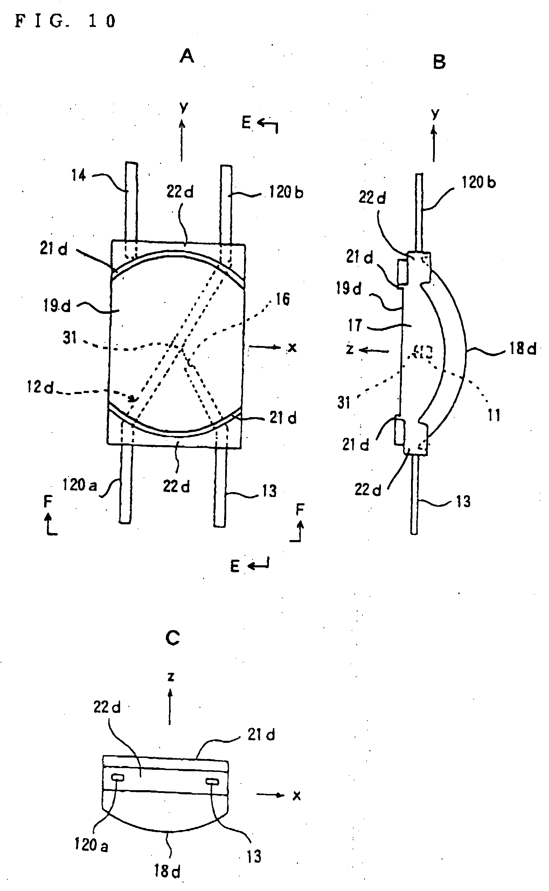

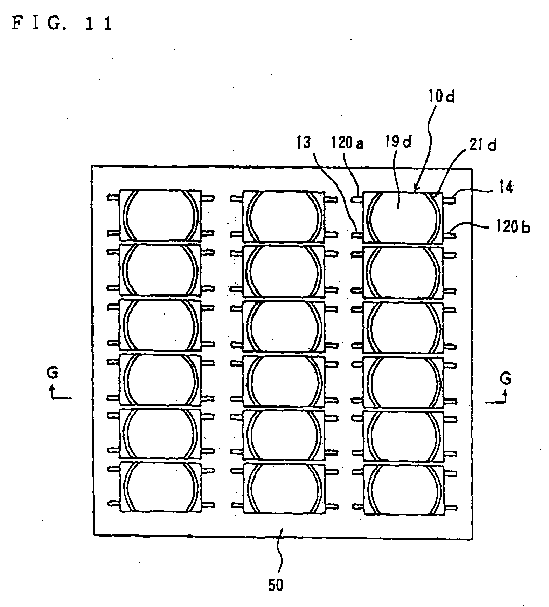

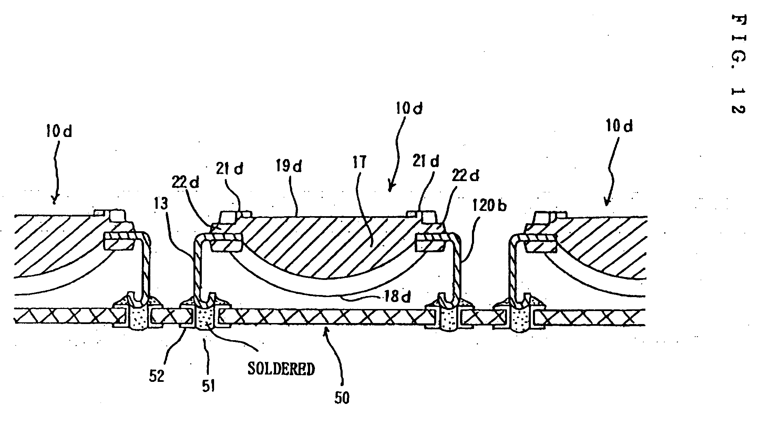

A fourth embodiment according to the present invention will hereinafter be described with reference to the drawings. FIG. 10A is a schematic front view of a reflection type light-emitting diode according to the fourth embodiment of the present invention. FIG. 10B is a schematic side view illustrating the reflection type light-emitting diode from the E - E direction of FIG. 10A. FIG. 10C is a schematic side view illustrating the reflection type light-emitting diode from the F - F direction in FIG. 10A. FIG. 11 is a schematic front view of a light-emitting diode arrangement using such reflection type light-emitting diode. FIG. 12 is a fragmentary cross-sectional view of the light-emitting diode arrangement taken along the line G - G in FIG. 11. In FIG. 10, the z-axis represents the center axis direction of the concave reflection surface, and the x-axis and the y-axis represent the orthogonal coordinates axes on the plane including the light-emitting surface of the light-emitting element.

As shown in FIGS. 10A, 10B, 10C and FIGS. 11 and 12, a reflection type light-emitting diode 10d comprises the light-emitting element 11, a first lead assembly 12d, the second lead assembly 13, a third lead assembly 14, the bonding wire 16, the light-transmissible material 17, a concave reflection surface 18d, a radiation surface 19d, a protruded portion 21d and a lead deriving portion 22d. In the light-emitting diode 10d according to the fourth embodiment, elements and parts having functions identical to those of the first embodiment are marked with the same reference numerals, and therefore need not be described in detail.

In general, the reflection type light-emitting diode can be reduced in thickness as compared with the lens type light-emitting diode. Accordingly, when the light-emitting element is sealed by a resin, the influence exerted on the reflection type light-emitting diode by the contraction of resin is small. There is then the advantage that the diameter of the concave reflection surface (or radiation surface) can be increased. In the fourth embodiment, let us consider specifically the case in which the diameter of the radiation surface 19d is set to 10 mm which is larger than the diameter (5 mm) of the radiation surface of the first embodiment. However, in the light-emitting diode according to the first embodiment, if the diameter of the radiation surface is selected to be 10 mm, then the lead assembly is extended too much. As a result, when the lead frame is manufactured by press punching work, the warping phenomenon of the lead becomes serious. There is then the problem that the positional accuracy of the portion in which the light-emitting element is mounted on the first lead assembly is degraded. Such problem becomes remarkable as the diameter of the radiation surface increases. In the fourth embodiment, it is a main theme to solve the problem that the positional accuracy of the light-emitting element relative to the concave reflection surface is degraded by the warping phenomenon of the lead.

The first lead assembly 12d and the second lead assembly 13 are adapted to supply electric power to the light-emitting element 11. The light-emitting element 11 is mounted at approximately the central portion (mount 31) of the first lead assembly 12d. The light-emitting element 11 and the second lead assembly 13 are electrically interconnected with each other by the bonding wire 16. Also, the light-emitting element 11, a part of the first lead assembly 12d, the tip end of the second lead assembly 13, the tip end of the third lead assembly 14 and the bonding wire 16 are integrally sealed by the thermosetting light-transmissible material 17.

The first lead assembly 12d is shaped so as to substantially rectilinearly cross the concave reflection surface 18d when the concave reflection surface 18d is seen from the front. Lead main bodies 120a, 120b, which are the portions except the mount 31 of the first lead assembly 12d, are led to the outside from the side surfaces of the light-transmissible material 17. The third load assembly 14 is attached to the lead deriving portion 22d. One lead main body 120a of the first lead assembly 12d and the second lead assembly 13; the other lead main body 120b of the first lead assembly 12d and the third lead assembly 14 are led out from the side surfaces of the light-transmissible material 17 in the directions opposite to each other.

The lead main body 120b of the first lead assembly 12d and the third lead assembly 14 are not related to the electrical interconnection unlike the lead main body 120a of the first lead assembly 12d and the second lead assembly 13 both of which serve as electrical terminals, and are used to fix the light-emitting diode 10d to the substrate. Therefore, the lead main body 120b of the first lead assembly 12d and the third lead assembly 14 can be referred to as fixing leads. On the other hand, the lead main body 120a of the first lead assembly 12d and the second lead assembly 13 are used not only to supply electric power to the light-emitting element 11 but also to fix the light-emitting diode 10d to the substrate. Therefore, the lead main body 120a of the first lead assembly 12d and the second lead assembly 13 can be referred to as power-supply and fixing leads.

The concave reflection surface 18d, the radiation surface 19d, the protruded portion 21d and the lead deriving portion 22d are respectively similar to the concave reflection surface, the radiation surface, the protruded portion and the lead deriving portion in the first embodiment. However, in the fourth embodiment, the end portion of the concave reflection surface 18d is symmetrically cut by two planes perpendicular to a straight line (e.g. x-axis), which passes the center of the concave reflection surface 18d when the concave reflection surface 18d is seen from the front and which is perpendicular to the center axis of the concave reflection surface 18d. Here, the end portion of the concave reflection surface 18d is cut in such a manner that a ratio of the length of the concave reflection surface 18d obtained after cutting to the length of the concave reflection surface 18d obtained before cutting in the x-axis direction when the concave reflection surface 18d is seen from the front becomes about 0.7. The reason that the end portion of the concave reflection surface 18d is cut is that the interval in which the light-emitting diodes 10d are arrayed may be reduced by arranging the light-emitting diodes 10d in such a fashion that the cut surfaces of the concave reflection surface 18d become adjacent to each other.

The lead deriving portion 22d are adapted to lead the respective lead assemblies 12d, 13, 14 to the outside. The lead deriving portions 22d are formed at outer peripheral sides of the concave reflection surface 18d and the radiation surface 19d. In the fourth embodiment, since the end portion of the concave reflection surface 18d is cut symmetrically, the protruded portions 21d and the lead deriving portions 22d are formed on the upper and lower portions of the radiation surface 19d as shown in FIG. 10A.

When such light emitting diode 10d is manufactured, similarly to the light-emitting diode according to the first embodiment, the lead frame is used and the light-emitting diode is fabricated on the lead frame by transfer molding. At that time, the concave reflection surface 18d is molded by the lower molding die and the radiation surface 19d is molded by the upper molding die. When this transfer molding is used, the concave reflection surface 18d, the radiation surface 19d and the lead deriving portion 22d can be molded with a high accuracy. In addition, their shapes are very stable. Also, as the lead frame, there can be used a product which is produced by press punching work in consideration of mass-production. Then, the light-emitting diode 10d having the respective lead assemblies 12d, 13, 14 can be obtained as shown in FIGS. 10A, 10B, 10C by removing the undesired portions of the lead frame by cutting. Finally, in the light-emitting diode 10d, as shown in FIG. 12, the lead assemblies 12d, 13, 14 led out from the lead deriving portion 22d are bent at approximately a right angle to the side of the concave reflection surface 18d near the lead deriving portion 22d and the tip ends of the respective lead assemblies 12d, 13, 14 are bend to the inside.

The light-emitting diode arrangement shown in FIGS. 11 and 12 comprises a plurality of light-emitting diodes 10d and a substrate 50. Here, let us describe the manner in which a plurality of light-emitting diodes 10d are densely arrayed on the substrate 50 in a matrix fashion.

As shown in FIG. 12, a large number of through-holes 51 and a large number of pads (electrodes) 52 are formed on the substrate 50. The through-holes 51 are formed on the light-emitting diode 10d at the positions opposing the respective lead assemblies 12d, 13, 14. The diameter of the through-hole 51 is designed to be slightly larger than the width of the lead assembly. The pads 52 are formed on the inner surface of the through-holes 51 and on the substrate 50 at its portion near the through-holes 51. Moreover, on the surface of the substrate 50, there is formed a circuit pattern (not shown) for interconnecting the lead main body 120a of the first lead assembly 12d and the second lead assembly 13.

When the light-emitting diode arrangement is formed by using a plurality of light-emitting diodes 10d, initially, a cream solder is coated on the substrate 50 at its portion in which the through-holes 51 are formed from the surface side of the substrate 50. Then, the lead assemblies 12d, 13, 14 of a plurality of light-emitting diodes 10d are disposed at the positions of the through-holes 51. At that time, since the diameter of the through-hole 51 is larger than the width of the lead assembly of the light-emitting diode 10d and the tip ends of the lead assemblies are bent inwardly, the lead assemblies of the light-emitting diode 10d can be disposed on the through-holes 51 of the substrate 50 with a stability.

Then, a soldering iron is pressed against the substrate at its portion in which the through-holes 51 are formed from the rear side of the substrate to conduct heat to the surface side of the substrate 50, whereby the cream solder is fused to solder the respective lead assemblies 12d, 13, 14 of the light-emitting diode 10d disposed on the substrate 50 to the substrate 50 at its position where the through-holes 51 are formed. By soldering, the light-emitting diode 10d is fixed and the lead main body 120a of the first lead assembly 12d and the second lead assembly 13 are interconnected with the circuit pattern (not shown) printed on the substrate 50. In this manner, a plurality of light-emitting diodes 10d are densely arrayed in a ,matrix fashion so that the cut surfaces of the concave reflection surface 18d become adjacent to each other, thereby resulting in the light-emitting diode arrangement shown in FIG. 11 being produced.

A method of attaching the light-emitting diodes to the substrate is not limited to the above-mentioned method in which the tip ends of the lead assemblies are bent inwardly, and it is possible to use a method in which a lead insertion aperture is bored at a predetermined position of a substrate, the tip end of the lead assembly is inserted into this aperture and the lead assembly is soldered. When the latter method is used, in order to protect the bottom of the concave reflection surface from contacting with the substrate, a large hole should preferably be bored through the substrate at its position opposing the concave reflection surface or a spacer should preferably be inserted between the lead deriving portion and the substrate.

In the light-emitting diode according to the fourth embodiment, since the protruded portion protruded from the radiation surface is formed around the radiation surface, and the concave reflection surface is molded by the lower molding die and the radiation surface is molded by the upper molding die according to transfer molding, similarly to the light-emitting diode according to the first embodiment, the radiation surface can be accurately produced with exactly the same shape as that of the upper molding die, thereby making it possible to improve the molding accuracy of the radiation surface. Therefore, the problem of appearance can be removed and the radiation characteristic on the radiation surface can be obtained as it is wanted to be in the design.

Also, in the light-emitting diode according to the fourth embodiment, since the first lead assembly for mounting the light-emitting element is shaped such that it crosses the concave reflection surface substantially rectilinearly when the concave reflection surface is seen from the front, the light-emitting element is mounted at substantially the central portion of the first lead assembly. Thus, even when the lead frame having such first lead assembly is manufactured by press punching work, the first lead assembly at its portion in which the light-emitting element is mounted is extremely slightly deformed by such work. Therefore, when the light-emitting diode is manufactured by using such lead frame, the positional accuracy of the light-emitting element relative to the concave reflection surface can be maintained with a stability. Accordingly, not only light radiated from the light-emitting element to the center axis direction but also light radiated in the direction approximately perpendicular to the center axis direction can be satisfactorily controlled by the concave reflection surface and then radiated to the outside.

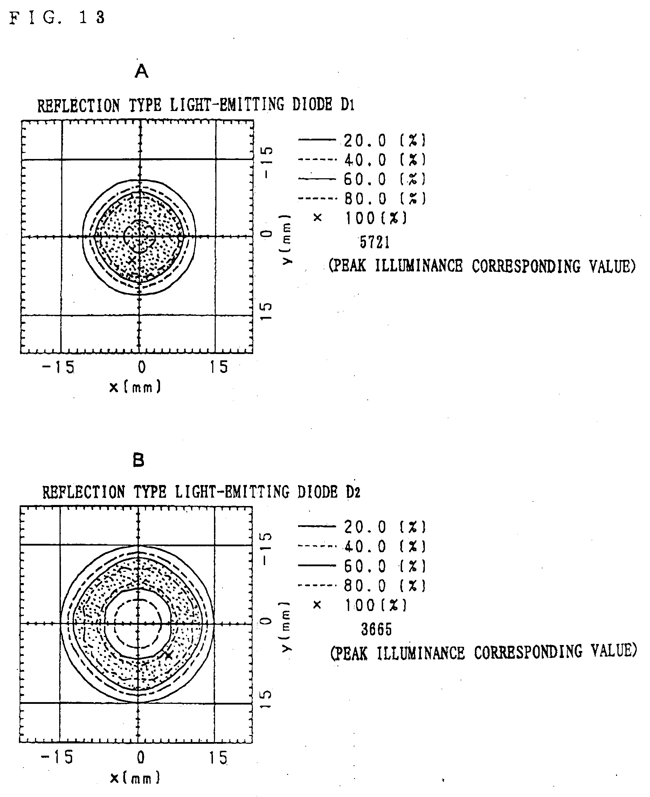

The inventors of the present application effected the simulation in order to examine the influence exerted by the lead warping phenomenon upon the light radiation characteristic of the light-emitting diode. That simulation used two kinds of light-emitting diode $D_1$, $D_2$ to examine the irradiation distribution on the plane of a target distant from the radiation surface 19 by 100 mm. Here, the light-emitting diode $D_1$ is produced by forming the shape of the concave reflection surface 18d as shown in FIG. 3. On the other hand, the light-emitting diode $D_2$ is such one that the center of the light-emitting surface of the light-emitting element 11 is shifted by 0.1 mm in the direction of the concave reflection surface side along the z-axis direction in the light-emitting diode $D_1$. In the respective light-emitting diodes $D_1$, $D_2$, the ends of the concave reflection surfaces are not cut. FIG. 13A is a diagram showing simulated results of the irradiation distribution with respect to the light-emitting diode $D_1$. FIG. 13B is a diagram showing simulated results of the irradiation distribution with respect to the light-emitting diode $D_2$. FIGS. 13A and 13B show distributions of illuminance ratios obtained when the peak illuminance is set to 100%. FIGS. 13A and 13B show the portions obtained when the illuminance ratio is greater than 60% as the dotted area. As shown in FIG. 13A, in the light-emitting diode $D_1$, a distribution in which the peak illuminance is higher than 60% is substantially circular so that parallel light can be irradiated on the target plane. On the other hand, with respect to the light-emitting diode $D_2$, as shown in FIG. 13B, the illuminance distribution is widened as compared with the illuminance distribution of FIG. 13A, and the peak illuminance is lowered by several ten percents. In addition, in the light-emitting diode $D_2$, the distribution in which the peak illuminance is greater than 60% becomes approximately doughnut-shape so that the illuminance near the center axis of the concave reflection surface 18 on the target plane is lowered considerably. That is, even when the lead is warped very slightly, the light radiation characteristic of the light-emitting diode is affected considerably. Accordingly, in the light-emitting diode according to the fourth embodiment, since the positional accuracy of the light-emitting element relative to the concave reflection surface can be maintained with a stability, the light radiation characteristic can be protected from being affected considerably, and hence parallel light can effectively be radiated to the outside.

Also, in the light-emitting diode according to the fourth embodiment, since the both ends of the first lead assembly are led out from the side surface of the light-transmissible material, heat generated from the light-emitting element is conducted to both ends of the first lead assembly in the two directions and heat conducted from the light-emitting element to the first lead assembly can be diffused to the outside from the both ends of the first lead assembly, and thus a heat radiation property can be improved. Therefore, the light-emitting output can be prevented from being lowered due to a rise of a temperature in the light-emitting element, and the life characteristic of the light-emitting element can be prevented from being deteriorated. Since the reflection type light-emitting diode is thin and the first lead assembly is formed at the position near the radiation surface, a part of heat conducted from the light-emitting element to the first lead assembly is radiated from the radiation surface to the outside. In the fourth embodiment, since the ratio in which the first lead assembly overlaps with the radiation surface obtained when the concave reflection surface is seen from the front is large as compared with that of the related-art light-emitting diode shown in FIGS. 18A and 18B, the quantity of heat radiated from the radiation surface to the outside can be increased, and hence the heat radiation property can be improved.

The inventors of this application has measured the rise of junction temperature of the light-emitting element after the junction temperature of the light-emitting element became stable since the light-emitting element had been energized at a power consumption of 36 mW for about 10 minutes with respect to the following respective light-emitting diodes. That experiments were conducted on the related-art reflection type light-emitting diode shod in FIGS. 18A, 18B, the reflection type light-emitting diode according to the fourth embodiment and the lens type light-emitting diode formed by molding the epoxy resin. Here, as the light-emitting diode according to the related art shown in FIGS. 18A and 18B, there was used the light-emitting diode in which the end surface of the concave reflection surface is cut similarly to the light-emitting diode according to the fourth embodiment. A study of experimental results shows that the rise of the junction temperature of the light-emitting element was 6.0°C in the related-art light-emitting diode, 4.8°C in the light-emitting diode according to the fourth embodiment and 9.2°C in the lens type light-emitting diode produced by molding the epoxy resin. Accordingly, it was confirmed that the rise of the junction temperature of the light-emitting element in the light-emitting diode according to the fourth embodiment was reduced to 80% as compared with the related-art light-emitting diode.

Also, since the light-emitting diode arrangement is comprised of the light-emitting diodes according to the fourth embodiment, heat generated from the light-emitting element can be widely diffused to the outside through the heat radiation route from the first lead assembly and the heat radiation route from the radiation surface so that the heat radiation property can be improved and that the rise of the temperature from the light-emitting element can be suppressed effectively.

In the above-mentioned fourth embodiment, when only the positional accuracy of the light-emitting element relative to the concave reflection surface should be maintained with stability and the heat radiation property need not be improved, the width of the first lead assembly 12d, shown in FIGS. 10A to 10C, at its side opposing the lead main body 120b may be made narrower than that of the first lead assembly 12d at its side opposing the lead main body 120a.

Also, while the product produced by press punching work is used as the lead frame in consideration of the mass-production in the above-mentioned fourth embodiment, when only the heat radiation characteristic should be improved, as the lead frame, there may be used a lead frame produced by etching work.

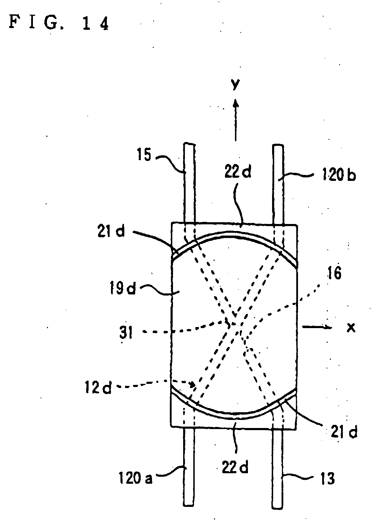

Moreover, while the light-emitting diode includes the third lead assembly attached to the lead deriving portion as described in the fourth embodiment, instead of the third lead assembly, as shown in FIG. 14, for example, there may be provided a fourth lead assembly 15 one end of which is joined to the mount 31 of the first lead assembly 12d and the other end of which is led out from the side surface of the light-transmissible material. Here, the lead main body 120a of the first lead assembly 12d and the second lead assembly 13; and the lead main body 120b of the first lead assembly 12d and the other end of the fourth lead assembly 15 are led out from the side surface of the light-transmissible material in the directions opposite to each other. Thus, the heat radiation route for radiating heat generated from the light-emitting element increases, and heat conducted from the light-emitting element to the fourth lead assembly 15 can be radiated to the outside from the end of the fourth lead assembly 15. In addition, since a part of heat conducted from the light-emitting element to the fourth lead assembly 15 can be radiated from the radiation surface 19d to the outside, it is possible to improve the heat radiation property much more.

In general, in the reflection type light-emitting diode, the portion of the lead assembly which overlaps with the radiation surface when the concave reflection surface is seen from the front hinders light, which was reflected on the concave reflection surface since it had been emitted from the light-emitting element, from being radiated to the outside. When the diameter of the concave reflection surface is selected to be about 10 mm and the width of the lead assembly is selected to be about 0.3 mm, the loss of external radiation from the lead assembly falls within a range of about 6 to 7% in the related-art light-emitting diode (light-emitting diode shown in FIG. 18 in which the end surface of the concave reflection surface is cut). On the other hand, in the light-emitting diode shown in FIG. 14, the loss Of the external radiation from the lead assembly is approximately 10% and becomes about a little less than twice the loss of the external radiation in the related-art light-emitting diode. However, according to the specification in which parallel light is radiated to the outside, considering that the reflection type light-emitting diode has an external radiation efficiency of more than three times that of the lens type light-emitting diode, it can be considered that the loss of the external radiation in the light-emitting diode shown in FIG. 14 can be neglected as compared with the light-emitting diode according to the related art. The light-emitting diode shown in FIG. 14 is suitable for use with, in particular, a light-emitting diode of the type which is energized by a large current.

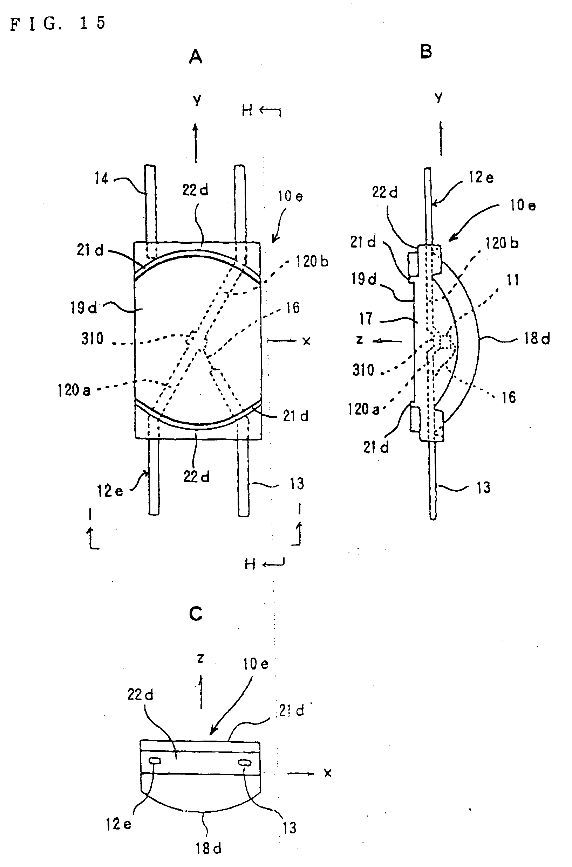

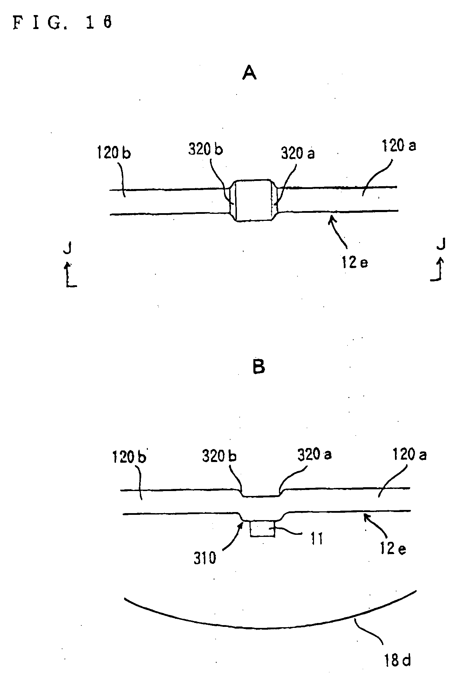

Next, a fifth embodiment according to the present invention will be described below with reference to the drawings. FIG. 15A is a schematic front view of a reflection type light-emitting diode according to the fifth embodiment of the present invention. FIG. 15B is a schematic side view illustrating the reflection type light-emitting diode from the H - H direction in FIG. 15A. FIG. 15C is a schematic side view illustrating the reflection type light-emitting diode from the I - I direction in FIG. 15A. FIG. 16A is a schematic front view of a mount of a first lead assembly in the reflection type light-emitting diode. FIG. 16B is a schematic side view illustrating the mount of the first lead assembly from the J - J direction in FIG. 16A.

As shown in FIGS. 15A to 15C, a reflection type light-emitting diode 10e comprises the light-emitting element 11, a first lead assembly 12e, the second lead assembly 13, the third lead assembly 14, the bonding wire 16, the light-transmissible material 17, the concave reflection surface 18d, the radiation surface 19d, the protruded portion 21d and a lead deriving portion 22d. In the fifth embodiment, elements and parts having functions identical to those of the fourth embodiment are marked with the same reference numerals, and therefore need not be described in detail.

The first lead assembly 12e and the second lead assembly 13 are adapted to supply electric power to the light-emitting element 11. The light-emitting element 11 is mounted at approximately a central portion (mount 310) of the first lead assembly 12e. Also, the light-emitting element 11, a part of the first lead assembly 12e, the tip end of the second lead assembly 13, the tip end of the third lead assembly 14 and the bonding wire 16 are integrally sealed by the light-transmissible material 17.

The first lead assembly 12e is shaped such that it may cross the concave reflection surface 18d approximately rectilinearly when the concave reflection surface 18d is seen from the front. The lead main bodies 120a, 120b, which are the portions except the mount 310 of the first lead assembly 12e, are lead to the outside from the side surfaces of the light-transmissible material 17. The third lead assembly 14 is attached to the lead deriving portion 22d. The lead main body 120a of the first lead assembly 12e and the second lead assembly 13; and the lead main body 120b of the first lead assembly 12e and the third lead assembly 14 are led out from the side surfaces of the light-transmissible material 17 in the directions opposite to each other.

Also, the lead main body 120b of the first lead assembly 12e and the third lead assembly 14 are not related to the electrical interconnection, and used to fix the light-emitting diode 10e to the substrate. On the other hand, the lead main body 120a of the first lead assembly 12e and the second lead assembly 13 are used not only to supply electric power to the light-emitting element 11 but also to fix the light-emitting diode 10e to the substrate.

At present, there are manufactured a variety of light-emitting elements. As the most popular light-emitting element, there is known a light-emitting element having a height of 0.3 mm. In addition, there is known a light-emitting element having a height of 0.2 mm in which a substrate on which layers are epitaxially deposited is removed in order to effect a large output and a high-speed response. Also, in a GaN light-emitting element using a sapphire substrate, there is a light-emitting element having a height of 0.1 mm. As described above, the light-emitting elements have various heights. In the fifth embodiment, considering characteristics of a variety of light-emitting elements, as the light-emitting element 11, there is used a light-emitting element thinner than the light-emitting element which would have been used in the first design. In this case, if the light-emitting element 11 is mounted on the flat first lead assembly as it is, the position of the light-emitting surface of the light-emitting element 11 relative to the concave reflection surface 18d is displaced in the height direction (z-axis direction). If the position of the light-emitting element 11 had been shifted in the height direction, then light radiated in the direction other than the z-axis direction from the light-emitting element 11 would not be satisfactorily controlled on the concave reflection surface 18d, the light radiation characteristic would be fluctuated and shifted from the desired characteristic.

Heretofore, there is proposed a method in which the position of the light-emitting element relative to the concave reflection surface is adjusted by a spacer inserted between the lead assembly at its portion in which the light-emitting element is mounted and the light-emitting element. However, according to the previously-proposed method using the inserted spacer, the spacer is mounted on the lead assembly through a conductive adhesive, and thereafter the conductive adhesive is hardened by heat. Therefore, it takes a time to manufacture the light-emitting diode. Moreover, when a metal chip is used as a spacer, if such metal chip is produced by press punching work, then there is produced a burr. In addition, since the metal chip is small, it is difficult to remove such burr. On the other hand, if the metal chip is produced by etching work, then it is difficult to hold such small metal chip. As described above, there are limitations on the materials of the spacer and a spacer having excellent thermal conductivity and excellent electrical conductivity cannot be used so that the characteristic of the light-emitting diode is lowered. Accordingly, if the position of the light-emitting element in the height direction had been adjusted by the previously-proposed method of inserting the spacer, there would arise another problem. Hence, such method is not the effective solving means.

Therefore, according to the fifth embodiment, as shown in FIG. 16A, 16B, the mount 310 of the first lead assembly 12e is protruded from the radiation surface 19d side to the side of the concave reflection surface 18d by punching work. Here, the surface of the mount 310 at its side opposing the concave reflection surface 18d is formed in approximately parallel to the surfaces of the lead main bodies 120a, 120b of the first lead assembly 12e. Thus, the surface of the mount 310 opposing the concave reflection surface 18d can be protruded to the side of the concave reflection surface 18d in the height direction relative to the surfaces of the lead main bodies 120a, 120b opposing the concave reflection surface 18d. Therefore, it is possible to adjust the position of the light-emitting element 11 mounted on the mount 310 in the height direction.

As shown in FIGS. 16A and 116B, on the end edge of the mount 310, there are provided support portions 320a, 320b for supporting the mount 310 in order to protect the mount 310 from being deformed by a load imposed when the light-emitting element 11 is mounted on the mount 310. In the fifth embodiment, as shown in FIG. 16A, the mount 310 is recessed by conducting punching work on the whole of the mount 310 with the result that the ends of the mount 310 of the lead main bodies 120a, 120b located at the left and right of the mount 310 are formed as the support portions 320a, 320b, respectively. Also, the tip ends of the support portions 320a, 320b opposing the radiation surface 19d are flush with the plane including the surfaces of the lead main bodies 120a, 120b opposing the radiation surface 19d.

A method of manufacturing a light-emitting diode according to the fifth embodiment will be described next. When such light-emitting diode is manufactured, initially, the lead frame is produced by press punching work. Then, as shown in FIG. 16A, the whole of the mount 310 of the lead frame produced by press punching work is treated by punching work. Then, the whole of the mount 310 is recessed so that the ends of the lead main bodies 120a, 120b opposing the mount 310 are formed as the support portions 320a, 320b. In such punching work, there can be used a commercially-available punching machine.

Thereafter, by using the lead frame treated by punching work, the light-emitting element 11 is mounted on the mount 310 of the lead frame. When such mount work is executed, the lead frame is placed in such a manner that the surface of the mount 310 opposing the concave reflection surface 18d is directed to the upper side. Hence, a load produced by the weight of the mounter head is imposed upon the light-emitting element11 placed on the mount 310. In the fifth embodiment, the support portions 320a, 320b are formed on the end edge of the mount 310. In addition, since the tip end surfaces of the support portions 320a, 320b opposing the radiation surface 19d are flush with the plane including the surfaces of the lead main bodies 120a, 120b opposing the radiation surface 19d, a parallelism between the surface of the mount 310 opposing the concave reflection surface 18d and the surfaces of the lead main bodies 120a, 120b can be protected from being lost due to this load. Then, the light-emitting element 11 and the lead frame at its portion corresponding to the second lead assembly 13 are interconnected with each other by the bonding wire 16. In such wire bonding process, an image at the electrode portion of the light-emitting element 11 can be acquired by light obtained when light is radiated to the light-emitting surface of the light-emitting element 11 in the vertical direction. At that time, when the light-emitting surface of the light-emitting element 11 is skewed relative to the radiation surface 19d with an inclination angle greater than 2°, it becomes difficult to recognize the image. However, according to the fifth embodiment, since the parallelism between the surface of the mount 310 opposing the concave reflection surface 18d and the surfaces of the lead main bodies 120a, 120b can be maintained, it is possible to satisfactorily recognize the image required in the wire bonding process.

When a Cu alloy having an excellent thermal conductivity is used as the lead frame, the Cu alloy tends to be softened so that the mount 310 should preferably be formed as a shape that is difficult to be deformed when the light-emitting element 11 to mounted thereon. Also, in the wire bonding process, it is customary that ultrasonic waves are used. Therefore, the mount 310 should preferably be shaped so as to prevent ultrasonic waves from being escaped.

Then, the light-emitting diode is produced on the lead frame thus obtained by transfer molding. At that time, the concave reflection surface 18d is molded by the lower molding die, and the radiation surface 19d is molded by the upper molding die. Then, there is obtained the light-emitting diode 10e having the respective lead assemblies 12e, 13, 14 shown in FIGS. 15A to 15C by removing undesired portions of the lead frame by cutting. Finally, the light-emitting diode 10e is processed such that the respective lead assemblies 12e, 13, 14 led out to the outside from the light-transmissible material 17 are bent to the rear side.

In the light-emitting diode according to the fifth embodiment, since the mount for mounting the light-emitting element of the first lead assembly is protruded from the radiation surface side to the concave reflection surface side by punching work, the light-emitting element can be mounted at the position of the height direction different from the surface of the first lead assembly opposing the concave reflection surface . Thus, when the thin light-emitting element, for example, is used, the position of the light-emitting element in the height direction can be adjusted by changing the height of the mount. Moreover, since the punching work can be implemented by using a commercially-available punching machine when the lead frame is produced, the manufacturing process of light-emitting diode can be prevented from becoming complex or the manufacturing work can be prevented from requiring plenty of time. Further, since the support portions are formed at the end edge of the mount and the tip end surfaces of the support portions opposing the radiation surface are flush with the plane including the surface of the lead main body of the first lead assembly opposing the radiation surface, when the light-emitting element is mounted on the mount by using such lead frame having such mount, it is possible to protect the mount from being deformed due to the load of the mounter head. Therefore, in the light-emitting diode produced by using such lead frame, the positional accuracy of the light-emitting element relative to the concave reflection surface can be maintained with a stability.

Also, in the light-emitting diode according to the fifth embodiment, since the mount is a part of the first lead assembly and is of course made of the lead material, the mount has an excellent thermal conductivity and an excellent electrical conductivity. As a result, it is possible to prevent the characteristic such as the heat radiation property from being lowered due to the thermal conductivity and the electrical conductivity of the mount. Moreover, if the thickness of the first lead assembly is selected properly, then even though the width of the first lead assembly is reduced, the mount can be treated by punching work. Therefore, by reducing the width of the lead assembly, it is possible to decrease the external reflection loss caused when the lead assembly hinders light reflected on the concave reflection surface from being radiated to the outside. Further, since the thickness of the mount is not reduced by punching work, heat generated from the light-emitting element can be satisfactorily conducted through the mount to the end of the first lead assembly so that the heat radiation property can be prevented from being lowered. Other effects achieved are similar to those of the fourth embodiment.

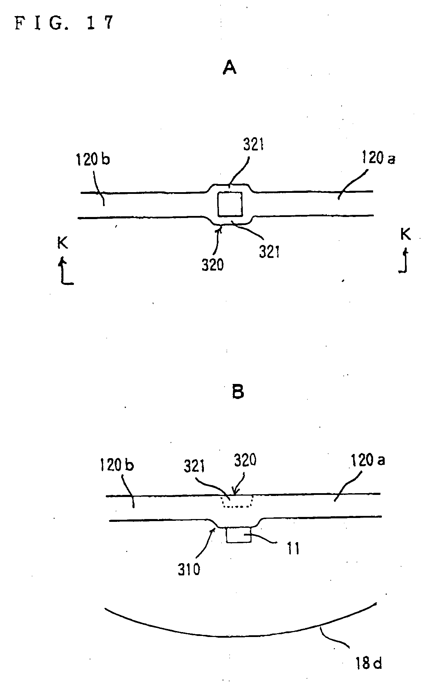

While punching work is conducted on the whole of the mount in the above-mentioned fifth embodiment, the present invention is not limited thereto, and in the fifth embodiment, punching work may be conducted on the central portion of the mount, for example, to form the support portion around the whole peripheral portion of the mount. FIG. 17A is a schematic front view of the mount obtained when punching work is conducted on the central portion of the mount in the fifth embodiment. FIG. 17B is a schematic side view illustrating the mount from the K - K direction in FIG. 17A. By conducting punching work on the central portion of the mount 310, as shown in FIGS. 17A and 17B, the surrounding portion at its central portion becomes a support portion 320. Since it is natural that the surface of the support portion 320 opposing the radiation surface 19d is flush with the surfaces of the lead main bodies 120a, 120b opposing the radiation surface 19d, the support portion 320 can support the mount 310 with a stability when the light-emitting element 11 is mounted on the mount 310. Moreover, in this case, upper and lower, portions 321 of the support portion 320 shown in FIG. 17A also can be utilized as heat routes for conducting heat generated from the light-emitting element 11 to the direction of the lead main bodies 120a, 120b. Therefore, the heat radiation characteristic can be improved much more.

The present invention is not limited to the above-mentioned respective embodiments and can be variously modified without departing from the scope of the invention.

For example, while the protruded portion is formed around the whole outer peripheral portion of the radiation surface in the first embodiment, the protruded portion is not always formed on the whole outer peripheral portion of the radiation surface. For example, in the first embodiment, a plurality of protruded portions may be formed around the radiation surface with a predetermined interval.

Also, while light emitted from the light-emitting element is radiated as parallel light in the above-mentioned respective embodiments, the present invention is not limited thereto, and in the first embodiment, the concave reflection surface may be shaped as approximately ellipsoid of revolution and the light-emitting element may be disposed at one of the focal points thereof. Thus, light passed through the radiation surface can be condensed at a constant region. Further, in the third embodiment, the second concave cylinder reflection surface may be shaped such that light emitted from the light-emitting element and light reflected on the intermediate reflection surface may be linearly condensed on the irradiated surface. In general, the shape of the optical surface may be designed in such a manner that light of a predetermined radiation characteristic, e.g. condensed light, parallel light, diffused light or the like may be radiated in response to the use of the light-emitting diode. However, since the influence exerted upon the radiation angle by the remaining air layer falls within several degrees, when the light radiation angle is large like a display light source which is requested to have a wide visibility angle, if the radiation angle is changed by several degrees, then there does not any problem. Therefore, the light-emitting diode according to the present invention can be suitably applied to the use in which a ray control with a high accuracy is required, e.g. the use in which light should be radiated to the distant range as parallel light or the use in which light should be condensed at one point or condensed linearly.

Further, the molding die of the planar optical surface can be produced with ease, and the influence from a characteristic standpoint is not caused due to the axis displacement of the upper molding die and the lower molding die. However, the problem of the remaining air layer becomes remarkable when the upper molding die forms the flat surface. Therefore, the present invention can be effectively applied to the light-emitting diode in which the radiation surface is planar. In the light-emitting diode according to the related art, when the distance between the surface of the lead assembly opposing the radiation surface and the radiation surface becomes longer than about 1.0mm, the influence of the remaining air layer becomes remarkable so that not only the problem of controlling rays of light but also the problem of appearance becomes remarkable. Therefore, the present invention may be effectively applied to such case. Further, since the quantity of air remaining on the upper surface of the upper molding die is reduced as the above-mentioned distance is reduced, even though the air layer remains in the portion of the upper molding die corresponding to the radiation surface, the influence exerted upon the molding accuracy of the radiation surface may be decreased. However, due to the reason from a manufacturing standpoint, the distance between the surface of the lead assembly opposing the radiation surface and the radiation surface should preferably be selected to be longer than 0.3 mm.

While the light-emitting diode is manufactured by transfer molding as described in the respective embodiments, the present invention is not limited thereto, and the light-emitting diode may be manufactured by multi-plunger molding using a plurality of plungers, for example.

Industrial Applicability:

As described above, the reflection type light-emitting diode according to the present invention can be utilized in wide fields of display field such as advertisement, information and signal, communication field such as optical fiber transmission and spatial transmission, optical device field such as OA devices, FA devices and precision measuring devices and biotechnology field such as plants breeding and living creature breeding.

**Claims**

1. A reflection type light-emitting diode comprising:

   a light-emitting element;
   a lead assembly for supplying electric power to said light-emitting element;
   a light-transmissible material for sealing said light-emitting element and said lead assembly;
   a concave reflection surface provided in an opposing relation to the light-emitting surface of said light-emitting element; and
   a radiation surface for radiating light reflected on said concave reflection surface to the outside,
   wherein said radiation surface has around its circumference formed a protruded portion protruded from said radiation surface, and said reflection type light-emitting diode is made by a molding method in which said concave reflection surface is molded by a lower molding die and said radiation surface is molded by an upper molding die.

2. A reflection type light-emitting diode as claimed in claim 1, wherein said radiation surface is planar and said concave reflection surface is shaped as approximately paraboloid of revolution using a center position of the light-emitting surface of said light-emitting element as a focal point.

3. A reflection type light-emitting diode as claimed in claim 1, wherein said radiation surface is planar and said concave reflection surface is shaped such that light which is emitted from said light-emitting element and reflected on said concave reflection surface is refracted on said radiation surface and condensed at one point.

4. A reflection type light-emitting diode comprising:

   a plurality of light-emitting elements arrayed rectilinearly;
   a lead assembly for supplying electric power to said plurality of light-emitting elements;
   a light-transmissible material for sealing said plurality of light-emitting elements and said lead assembly;
   a concave cylinder reflection surface provided in an opposing relation to the light-emitting surfaces of said plurality of light-emitting elements; and
   a radiation surface for radiating light reflected on said concave cylinder reflection surface to the outside,
   wherein said radiation surface has around its circumference formed a protruded portion protruded from said radiation surface, and said reflecting type light-emitting diode is made by a molding method in which said concave cylinder reflection surface is molded by a lower molding die and said radiation surface is molded by an upper molding die.

5. A reflection type light-emitting diode as claimed in claim 4, wherein intermediate reflection surfaces are disposed between said light-emitting elements, said concave cylinder reflection surface reflects light emitted from said light-emitting elements and light reflected on said intermediate reflection surfaces, said concave cylinder reflection surface is divided into two parts by a virtual surface including a straight line along which said light-emitting elements are disposed, one of said two parts of said concave cylinder reflection surface has a cross-section perpendicular to said straight line shaped as approximately a circle whose center is the position of said light-emitting element and the other of said two parts of said concave cylinder reflection surface has a cross-section perpendicular to said straight line shaped such that it reflects incident light and radiates the reflected light to the outside.

6. A reflection type light-emitting diode comprising:

   a light-emitting element;
   a first lead assembly having a mount for mounting said light-emitting element;
   a second lead assembly interconnected to said light-emitting element by a wire;
   a concave reflection surface provided in an opposing relation to the light-emitting surface of said light-emitting element;
   a radiation surface for radiating light reflected on said concave reflection surface to the outside; and
   a light-transmissible material for sealing said light-emitting element and a part of said first lead assembly and said second lead assembly and filling a space between said concave reflection surface and said radiation surface,
wherein said first lead assembly is shaped so as to cross said concave reflection surface substantially rectilinearly when said concave reflection surface is seen from the front and both end portions of said first lead assembly are led out to the outside from the side surface of said light-transmissible material.

7. A reflection type light-emitting diode as claimed in claim 6, wherein said radiation surface has around its circumference formed a protruded portion protruded from said radiation surface, and said reflection type light-emitting diode is made by a molding method in which said concave reflection surface is molded by a lower molding die and said radiation surface is molded by an upper molding die.

8. A reflection type light-emitting diode as claimed in claim 6, wherein said first lead assembly and said second lead assembly are formed by using a lead frame produced by press punching work.

9. A reflection type light-emitting diode according to claim 6, further comprising a third lead assembly attached to said light-transmissible material located at the peripheral portion of said concave reflection surface,
wherein one lead main portion of two lead main portions which are other portions than said mount of said first lead assembly and said second lead assembly, and the other of said lead main portions and said third lead assembly are led out from the side surfaces of said light-transmissible material in the directions opposite to each other.

10. A reflection type light-emitting diode according to claim 6, further comprising a fourth lead assembly one end of which is joined to said mount of said first lead assembly and the other and of which is led out from the side surface of said light-transmissible material to the outside.

11. A reflection type light-emitting diode as claimed in claim 10, wherein one lead main portion of two lead main portions which are other portions than said mount of said first lead assembly and said second lead assembly, and the other of said lead main portions and said fourth lead assembly are led out from the side surfaces of said light-transmissible material in the directions opposite to each other.

12. A reflection type light-emitting diode as claimed in claim 6, wherein said mount of said first lead assembly is protruded from said radiation surface side to said concave reflection surface side, said mount has on its end edge formed a support portion, and a tip end surface of said support portion opposing said radiation surface is flush with a plane including the surface of said radiation surface side of the portion except said mount of said first lead assembly.

13. A reflection type light-emitting diode as claimed in claim 12, wherein said support portion is formed on the whole circumference of said mount.

14. A light-emitting diode arrangement comprising a plurality of light-emitting diodes of claim 6 arrayed densely.

15. A method of manufacturing a reflection type light-emitting diode comprising a light-emitting element, a lead assembly for supplying electric power to said light-emitting element, a light-transmissible material for sealing said light-emitting element and said lead assembly, a concave reflection surface provided in an opposing relation to the light-emitting surface of said light-emitting element and a radiation surface for radiating light reflected on said concave reflection surface to the outside, comprising the steps of molding said concave reflection surface by a lower molding die and molding said radiation surface by an upper molding die such that said radiation surface has around its circumference formed a protruded portion protruded from said radiation surface.

24

F I G. 1

A

B

FIG. 2

FIG. 3

$$Z = \sum_{i=0}^{7} A_i \cdot x^i$$

WHERE

$A_0 = -2.5877014678 9 3$

$A_1 = -0.054300378443$

$A_2 = 0.203370511165$

$A_3 = -0.099854956816$

$A_4 = 0.052141059283$

$A_5 = -0.014504319626$

$A_6 = 0.002048212706$

$A_7 = -0.000115311060$

FIG. 4

F I G. 5

FIG. 6

FIG. 7

A

B

C

F I G. 8

**A**

**B**

FIG. 9

A

B

FIG. 10

FIG. 11

F I G.  1 2

F I G. 1 3

A

REFLECTION TYPE LIGHT-EMITTING DIODE D1

—— 20.0 [%]
------ 40.0 [%]
—— 60.0 [%]
------ 80.0 [%]
× 100 [%]
5721
(PEAK ILLUMINANCE CORRESPONDING VALUE)

x [mm]

y [mm]

B

REFLECTION TYPE LIGHT-EMITTING DIODE D2

—— 20.0 [%]
------ 40.0 [%]
—— 60.0 [%]
------ 80.0 [%]
× 100 [%]
3665
(PEAK ILLUMINANCE CORRESPONDING VALUE)

x [mm]

y [mm]

FIG. 14

FIG. 15

FIG. 16

A

B

F I G. 1 7

A

B

FIG. 18

A

96

97

L

L

92 b

93

97

92 a

B

z

96

94

97

92 a

91

95

93

92 b

97

## INTERNATIONAL SEARCH REPORT

| | International application No. |
|---|---|
| | PCT/JP98/00826 |

### A. CLASSIFICATION OF SUBJECT MATTER
Int.Cl⁶ H01L33/00

According to International Patent Classification (IPC) or to both national classification and IPC

### B. FIELDS SEARCHED

Minimum documentation searched (classification system followed by classification symbols)
Int.Cl⁶ H01L33/00

Documentation searched other than minimum documentation to the extent that such documents are included in the fields searched

| Jitsuyo Shinan Koho | 1922-1996 | Toroku Jitsuyo Shinan Koho | 1994-1998 |
|---|---|---|---|
| Kokai Jitsuyo Shinan Koho | 1971-1998 | Jitsuyo Shinan Toroku Koho | 1996-1998 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y<br>Y | JP, 08-018107, A (Iwasaki Electric Co., Ltd.),<br>January 19, 1996 (19. 01. 96),<br>Fig. 4<br>Fig. 2 (Family: none) | 1<br>2 |
| Y | JP, 05-152610, A (Iwasaki Electric Co., Ltd.),<br>June 18, 1993 (18. 06. 93),<br>Par. No. [0023] (Family: none) | 6-14 |
| A | JP, 05-190912, A (Iwasaki Electric Co., Ltd.),<br>July 30, 1993 (30. 07. 93),<br>Par. No. [0018] (Family: none) | 14 |
| A | JP, 09-102632, A (Sharp Corp.),<br>April 15, 1997 (15. 04. 97),<br>Par. Nos. [0015] to [0017] (Family: none) | 15 |

☐ Further documents are listed in the continuation of Box C. ☐ See patent family annex.

| * Special categories of cited documents: |  |
|---|---|
| "A" document defining the general state of the art which is not considered to be of particular relevance | "T" later document published after the international filing date or priority date and not in conflict with the application but cited to understand the principle or theory underlying the invention |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) |  |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search<br>May 21, 1998 (21. 05. 98) | Date of mailing of the international search report<br>June 2, 1998 (02. 06. 98) |
|---|---|
| Name and mailing address of the ISA/<br>Japanese Patent Office | Authorized officer |
| Facsimile No. | Telephone No. |

Form PCT/ISA/210 (second sheet) (July 1992)